# EUROPÄISCHE PATENTSCHRIFT

(11) **EP 3 414 778 B1**
(45) Veröffentlichungstag und Bekanntmachung des Hinweises auf die Patenterteilung: **05.02.2020**
(21) Anmeldenummer: 16816227.9
(22) Anmeldetag: 08.12.2016
(51) Int. Cl.: H01L 31/02

(54) **SCHUTZSCHALTUNG FÜR EIN PHOTOVOLTAIK (PV)-MODUL, VERFAHREN ZUM BETRIEB DER SCHUTZSCHALTUNG UND PHOTOVOLTAIK (PV)-ANLAGE MIT EINER DERARTIGEN SCHUTZSCHALTUNG**
PROTECTIVE CIRCUIT FOR A PHOTOVOLTAIC (PV) MODULE, METHOD FOR OPERATING THE PROTECTIVE CIRCUIT, AND PHOTOVOLTAIC (PV) SYSTEM HAVING SUCH A PROTECTIVE CIRCUIT
CIRCUIT DE PROTECTION D'UN MODULE PHOTOVOLTAÏQUE (PV), PROCÉDÉ DE FONCTIONNEMENT DU CIRCUIT DE PROTECTION ET INSTALLATION PHOTOVOLTAÏQUE (PV) ÉQUIPÉE D'UN TEL CIRCUIT DE PROTECTION

(30) Priorität: 11.02.2016 DE 102016102417
(43) Veröffentlichungstag der Anmeldung: 19.12.2018
(73) Patentinhaber: SMA Solar Technology AG, 34266 Niestetal (DE)
(72) Erfinder: HOPF, Markus, 34314 Espenau (DE); MUELLER, Burkard, 34123 Kassel (DE)
(86) Internationale Anmeldenummer: PCT/EP2016/080227
(87) Internationale Veröffentlichungsnummer: WO 2017/137114

(56) Entgegenhaltungen:
- WO-A2-2010/078303
- WO-A2-2011/023732
- DE-A1-102010 023 549
- DE-A1-102013 106 808

## Beschreibung

### TECHNISCHES GEBIET DER ERFINDUNG

Die Erfindung bezieht sich auf eine Schutzschaltung für ein Photovoltaik (PV)-Modul, ein Verfahren zum Betrieb einer derartigen Schutzschaltung und eine Photovoltaik (PV)-Anlage mit mehreren PV-Modulen, von denen zumindest ein PV-Modul eine derartige Schutzschaltung aufweist.

Unter einer Schutzschaltung ist eine einem PV-Modul nachgeschaltete elektrische Schaltung zu verstehen, die dazu ausgelegt ist, eine Energieabgabe des eingangsseitig an sie angeschlossenen PV-Moduls zu ermöglichen, oder andernfalls zu unterdrücken und das ihr zugeordnete PV-Modul freizuschalten. Eine derartige Schutzschaltung ist typischerweise in unmittelbarer Nähe zu dem ihr zugeordneten PV-Modul, z.B. in einer Anschlussdose des entsprechenden PV-Moduls angeordnet. Dabei ist eine Freischaltung des PV-Moduls insbesondere in einem Sicherheits- oder Gefahrenfall erwünscht, um hohe Spannungen an Verbindungsleitungen zwischen einer Serienschaltung von PV-Modulen und einem Photovoltaik (PV)-Wechselrichter einer PV-Anlage zu vermeiden. Ein derartiger Sicherheits- oder Gefahrenfall kann beispielsweise bei einem Brand eines Gebäudes, an dem die PV-Anlage installiert ist, eintreten. Über eine Freischaltung der PV-Module ist gewährleistet, dass die Anschlussleitungen zum Wechselrichter wie auch die Verbindungsleitungen der Serienschaltung von PV-Modulen untereinander spannungsfrei sind, zumindest jedoch eine Spannung unterhalb eines risikobehafteten Spannungswertes aufweisen. Auf diese Weise wird eine Gefährdung von Personen, beispielsweise den Brand bekämpfenden Feuerwehrleuten, ausgeschlossen.

Hauptaufgabe einer gattungsgemäßen Schutzschaltung ist somit eine Zuschaltung bzw. Freischaltung des ihr zugeordneten PV-Moduls. Zusätzlich zu dieser Hauptaufgabe kann eine Schutzschaltung aber auch weitere Aufgaben übernehmen. Entsprechende Aufgaben beinhalten zum Beispiel
- eine Detektion von elektrischen Parametern des der Schutzschaltung zugeordneten PV-Moduls,
- eine Auswertung der elektrischen Parameter und gegebenenfalls Initiierung einer Aktion in Reaktion auf diese Auswertung, beispielsweise eine Reduzierung einer Verlustleistung des der Schutzschaltung zugeordneten PV-Moduls bei Verschattung desselben, sowie
- eine Kommunikation mit anderen Schutzschaltungen von PV-Modulen und/oder mit einem PV-Wechselrichter einer PV-Anlage.

Da im Bedarfsfall üblicherweise jedes PV-Modul einer PV-Anlage mit einer entsprechenden Schutzschaltung ausgerüstet wird, ist es wünschenswert, dass die Schutzschaltung möglichst einfach und kostengünstig, insbesondere mit möglichst geringem Bauteilaufwand aufgebaut werden kann.

### STAND DER TECHNIK

Aus der US 2015 0131187 A1 ist eine Schaltung und ein Verfahren zum Schutz eines PV-Strings bekannt. Die Schaltung weist einen parallel zu dem PV-String geschalteten Bypass-Schalter und einen in Reihe zu dem PV-String geschalteten Hot-Spot-Schalter auf. Bei Detektion eines Hot-Spot Zustandes wird zunächst der Bypass-Schalter über ein erstes Steuersignal geschlossen und danach der Hot-Spot-Schalter über ein zweites Steuersignal geöffnet.

Aus der WO 2011 023732 A2 ist eine Bypass- und Schutzschaltung für ein PV-Modul bekannt. Die Bypass- und Schutzschaltung umfasst einen Eingang zum Anschluss des PV-Moduls und einen Ausgang. Die Schutzschaltung umfasst ferner ein Bypass-Element, das parallel zu dem Ausgang der Schutzschaltung geschaltet ist, sowie ein Trenn-Element, das zwischen dem Eingang und dem Ausgang geschaltet ist. Dabei ist das Trenn-Element konfiguriert, eine Verbindung zwischen dem Eingang und dem Ausgang zu steuern. Eine Steuerung zur Ansteuerung des Trennelementes versorgt sich aus dem eingangsseitig an die Schutzschaltung angeschlossenen PV-Modul.

Bei geöffnetem Trenn-Element wird eine Energieabgabe des PV-Moduls an den Ausgang der Schutzschaltung verhindert. Die Steuerung der Schutzschaltung versorgt sich dabei weiterhin aus dem eingangsseitig angeschlossenen PV-Modul. Für einen korrekten Betrieb der Schutzschaltung ist es daher erforderlich, dass eingangsseitig stets ein PV-Modul angeschlossen ist. Weiterhin ist es erforderlich, dass das angeschlossene PV-Modul in jedem Betriebszustand, insbesondere also auch bei extremer Verschattung, ausreichend Spannung bzw. elektrische Leistung zur Versorgung der Steuerung der ihm zugeordneten Schutzschaltung bereitstellt. Das ist insbesondere in einem Wartungsfall, der z.B. einen Austausch des PV-Moduls erfordert und/oder bei einem Defekt der Anschlussleitung zwischen PV-Modul und Schutzschaltung, nicht, zumindest jedoch nicht sicher gegeben. Weiterhin kann eine extreme Verschattung des PV-Moduls dazu führen, dass eine zur Versorgung der Steuerung erforderliche Leistung über das eingangsseitig angeschlossene PV-Modul nicht, zumindest jedoch nicht sicher, bereitgestellt werden kann.

Das Dokument DE 10 2013 101 314 A1 offenbart eine PV-Anlage mit zumindest einem PV-String aus PV-Modulen und einem System zum einzelnen Freischalten der PV-Module, sowie zum sicheren erstmaligen Anschalten oder Wiederanschalten der freigeschalteten PV-Module. Dabei sind Solaranschlussdosen der PV-Module zumindest teilweise "intelligent" ausgebildet und weisen eine Sicherheitsschaltung auf, die einen Betriebszustand und einen Sicherheitszustand definiert. Die Solaranschlussdosen werden durch das Einprägen eines Startstroms oder Startsignals vom Sicherheitszustand in den Betriebszustand umgeschaltet. Hierzu weist das System eine zwischen einem PV-Wechselrichter und dem PV-String geschaltete Startbox auf, die ausgelegt ist, sich über ihren Eingang durch den dort angeschlossenen PV-String oder über ihren Ausgang zu versorgen. Dabei erfolgt eine Versorgung über den Ausgang der Startbox über einen Rückstrom, der einem Strom im normalen Betrieb der PV-Anlage entgegengerichtet ist.

Die DE 10 2010 023 549 A1 offenbart eine Modulelektronik zur Verbindung eines PV-Moduls mit einem Gleichstromnetz eines PV-Generators. Die Modulelektronik umfasst ein erstes Schaltelement zwischen einem ersten Modulanschluss des PV-Moduls und einem ersten Netzanschluss des Gleichstromnetzes, ein zweites Schaltelement in einer Kurzschlussleitung zwischen dem ersten und dem zweiten Netzanschluss des Gleichstromnetzes, sowie eine Ansteuerelektronik, die mit den beiden Schaltelementen in steuernder Verbindung steht und eine elektrische Versorgungseinheit aufweist.

### AUFGABE DER ERFINDUNG

Der Erfindung liegt die Aufgabe zugrunde, eine Schutzschaltung für ein Photovoltaik (PV) - Modul aufzuzeigen, die in jedem Zustand des PV-Moduls, insbesondere auch bei einem nicht bzw. nicht korrekt angeschlossenen PV-Modul oder einem extrem verschatteten eingangsseitig an die Schutzschaltung angeschlossenen PV-Moduls sicher elektrisch versorgt wird. Dabei soll die Schutzschaltung möglichst einfach und kostengünstig aufgebaut werden. Weiterhin ist es Aufgabe der Erfindung, ein Betriebsverfahren für eine derartige Schutzschaltung anzugeben, sowie eine PV-Anlage mit einer derartigen Schutzschaltung aufzuzeigen.

### LÖSUNG

Die Aufgabe der Erfindung wird durch eine Schutzschaltung für ein Photovoltaik (PV) - Modul mit den Merkmalen des unabhängigen Patentanspruchs 1, sowie durch ein Betriebsverfahren für eine derartige Schutzschaltung gemäß dem unabhängigen Verfahrensanspruch 9 gelöst. Die abhängigen Patentansprüche 2 bis 8 sind auf bevorzugte Ausführungsformen der Schutzschaltung gerichtet, während die abhängigen Patentansprüche 10 bis 14 auf bevorzugte Ausführungsformen des Betriebsverfahrens abzielen. Der nebengeordnete Patentanspruch 15 betrifft eine Photovoltaik (PV) - Anlage mit einer derartigen Schutzschaltung.

### BESCHREIBUNG DER ERFINDUNG

Eine erfindungsgemäße Schutzschaltung für ein Photovoltaik (PV) - Modul, weist
- einen Eingang mit zwei Eingangsanschlüssen zum Anschluss des PV-Moduls und
- einen Ausgang mit zwei Ausgangsanschlüssen zum Anschluss weiterer PV-Module einer Serienschaltung von PV-Modulen auf. Weiterhin weist die Schutzschaltung
- einen ersten Schalter zur Verbindung eines der Eingangsanschlüsse mit einem der Ausgangsanschlüsse, und
- eine Steuerung konfiguriert zum Steuern des ersten Schalters auf.
Die Schutzschaltung ist dadurch gekennzeichnet, dass sie weiterhin
- einerseits eine Serienschaltung einer ersten Diode und eines Energiespeichers aufweist, wobei die Serienschaltung parallel zum Eingang der Schutzschaltung angeordnet ist, und
- andererseits eine zweite Diode aufweist, die einen Ausgangsanschluss der Schutzschaltung mit einem Mittelpunkt der Serienschaltung aus erster Diode und Energiespeicher verbindet. Dabei ist eine Serienschaltung aus der zweiten Diode und dem Energiespeicher parallel zu dem ersten Schalter geschaltet.

Dabei versorgt sich die Steuerung der Schutzschaltung, gegebenenfalls auch weitere Komponenten der Schutzschaltung oder auch die gesamte Schutzschaltung, aus dem Energiespeicher. Über die Serienschaltung aus erster Diode und Energiespeicher, die parallel zum Eingang der Schutzschaltung angeordnet ist, ist die Schutzschaltung in der Lage, den Energiespeicher aus dem an den Eingang der Schutzschaltung angeschlossenen PV-Modul aufzuladen. Dies ist beispielsweise in einem Normalzustand des PV-Moduls der Fall, bei dem die Serienschaltung der PV-Module - und damit auch das an den Eingang der Schutzschaltung angeschlossene PV-Modul - in einem Arbeitspunkt maximaler Leistung (MPP = Maximum Power Point) betrieben wird. In dem Normalzustand liegt an den Eingangsanschlüssen der Schutzschaltung daher üblicherweise eine dem MPP-Arbeitspunkt zugeordnete MPP-Spannung als Eingangsspannung an. Die an den Eingangsanschlüssen der Schutzschaltung anliegende Eingangsspannung Uₑᵢₙ ist in diesem Fall positiv, d.h. Uₑᵢₙ > 0 V. Dabei ist die Durchflussrichtung der ersten Diode derart orientiert, dass sie einerseits ein Aufladen des Energiespeichers im Normalzustand des PV-Moduls ermöglicht, andererseits jedoch eine Entladung des Energiespeichers über den Eingang der Schutzschaltung bei einem Absinken der an den Eingangsanschlüssen anliegenden Eingangsspannung Uₑᵢₙ verhindert. Im Normalzustand des PV-Moduls ist der erste Schalter üblicherweise dauerhaft geschlossen und verbindet so dauerhaft einen Eingangsanschluss mit dem diesem Eingangsanschluss zugeordneten Ausgangsanschluss.

Weiterhin wird über die zweite Diode, die einen Ausgangsanschluss der Schutzschaltung mit einem Mittelpunkt der Serienschaltung aus erster Diode und Energiespeicher verbindet, in Verbindung mit dem ersten Schalter eine Aufladung des Energiespeichers über die Ausgangsanschlüsse der Schutzschaltung ermöglicht. Zu diesem Zweck ist die zweite Diode derart verschaltet, dass eine Serienschaltung aus zweiter Diode und Energiespeicher parallel zu dem ersten Schalter geschaltet ist.

Ein Aufladen des Energiespeichers über die Ausgangsanschlüsse der Schutzschaltung erfolgt beispielsweise dann, wenn das an den Eingang angeschlossene PV-Modul verschattet ist und somit einen Polungszustand aufweist, der entgegengerichtet zu einem Polungszustand im Normalzustand des PV-Moduls ist. In diesem Fall ist die an den Eingangsanschlüssen anliegende Eingangsspannung Uₑᵢₙ der Schutzschaltung negativ, d.h. Uₑᵢₙ < 0 V. Aufgrund der negativen Eingangsspannung Uₑᵢₙ ist ein Aufladen des Energiespeichers aus dem an den Eingang angeschlossenen PV-Modul nicht möglich, eine Entladung des Energiespeichers über die Eingangsanschlüsse wird jedoch durch die erste Diode verhindert. Allerdings entlädt sich der Energiespeicher aufgrund des Energieverbrauches der Steuerung - und gegebenenfalls weiterer Komponenten der Schutzschaltung - im laufenden Betrieb. Um daher auch im verschatteten Zustand die Versorgung der Steuerung und den ordnungsgemäßen Betrieb der Schutzschaltung sicherzustellen, wird der Energiespeicher über die Ausgangsanschlüsse der Schutzschaltung aufgeladen, sofern dies z.B. aufgrund einer nicht ausreichenden Eingangsspannung Uₑᵢₙ über die Eingangsanschlüsse nicht möglich, für den ordnungsgemäßen Betrieb der Schutzschaltung aber erforderlich ist.

Um den Energiespeicher über die Ausgangsanschlüsse aufzuladen, wird ein Strom von einem Ausgangsanschluss der Schutzschaltung über den ersten Schalter zu dem anderen Ausgangsanschluss der Schutzschaltung geführt. Der erste Schalter wird nun ausgehend von einem anfänglich geschlossenen Zustand temporär geöffnet. Im geöffneten Zustand kommutiert der zuvor über den geschlossenen ersten Schalter fließende Strom auf die Serienschaltung aus zweiter Diode und Energiespeicher und lädt diesen auf. Ist der Energiespeicher ausreichend durch die aufgenommene Ladung aufgeladen, wird der erste Schalter wieder geschlossen und der Strom kommutiert zurück auf den ersten Schalter. Die Aufladung des Energiespeichers wird beendet und dieser entlädt sich wieder durch die Energieentnahme seitens der Steuerung und gegebenenfalls weiterer angeschlossener Komponenten im laufenden Betrieb der Schutzschaltung. Nach einem erneuten Absinken der im Energiespeicher gespeicherten Energie wird dieser Vorgang wiederholt.

Im verschatteten Zustand des an den Eingang angeschlossenen PV-Moduls wird der Strom durch die unverschatteten PV-Module innerhalb der Serienschaltung von PV-Modulen erzeugt. Der innerhalb der Serienschaltung fließende Strom wird dabei von einem Ausgangsanschluss der Schutzschaltung über einen Bypasspfad, der parallel zum Eingang der Schutzschaltung angeschlossen ist, zum anderen Ausgangsanschluss der Schutzschaltung geführt. Dabei muss der Bypasspfad nicht zwingend Bestandteil der Schutzschaltung selbst sein. So kann beispielsweise auch eine ohnehin am PV-Modul vorhandene Bypassdiode des an die Schutzschaltung angeschlossenen PV-Moduls als Bypasspfad operieren. Gleichwohl kann der Bypasspfad jedoch auch - zum Beispiel in Form eines zweiten Halbleiterschalters und/oder einer Bypassdiode - Bestandteil der Schutzschaltung selbst sein.

Die Schutzschaltung kann zusätzlich auch während eines Wartungszustandes des an die Schutzschaltung angeschlossenen PV-Moduls genutzt werden. Auch im Wartungszustand, bei dem üblicherweise das PV - Modul entfernt wird, wird der Energiespeicher über die Ausgangsanschlüsse, wie auch schon während des verschatteten Zustandes des PV-Moduls beschrieben, aufgeladen. Gegebenenfalls ist im Wartungszustand jedoch ein Bypasspfad parallel zum Eingang der Schutzschaltung bereitzustellen. Dies kann bei einem eingangsseitig nicht angeschlossenen PV-Modul durch eine elektrische Verbindung der Eingangsanschlüsse miteinander, z.B. über eine Drahtbrücke, erfolgen. Hierbei kann es zweckmäßig sein, die Eingangsanschlüsse in zweifacher Anzahl, einmal zum Anschluss des PV-Moduls und einmal zum Anschluss der Drahtbrücke, an ein Gehäuse der Schutzschaltung zu führen.

Sowohl im verschatteten Zustand als auch im Wartungszustand des eingangsseitig an die Schutzschaltung angeschlossenen PV-Moduls ist eine an den Ausgangsanschlüssen der Schutzschaltung, wie auch an dem ersten Schalter vorliegende Stromrichtung gleich einer Stromrichtung, wie sie im Falle eines Normalzustands des entsprechenden PV-Moduls an den jeweiligen Ausgangsanschlüssen beziehungsweise an dem ersten Schalter der Schutzschaltung vorliegt. Es handelt sich also nicht um einen Rückstrom über die Ausgangsanschlüsse der Schutzschaltung, der einer Stromrichtung im Normalzustand des entsprechenden PV-Moduls entgegengerichtet ist. Der Unterschied zum Normalzustand liegt vielmehr darin, dass der Strom im verschatteten Zustand wie auch im Wartungszustand nicht mehr von dem der Schutzschaltung zugeordneten PV-Modul, sondern vielmehr hauptsächlich von den benachbarten PV-Modulen der Serienschaltung erzeugt beziehungsweise getrieben wird. Indem nun die Serienschaltung aus zweiter Diode und Energiespeicher parallel zu dem ersten Schalter geschaltet ist, ist die Schutzschaltung ausgelegt, auch im verschatteten Zustand beziehungsweise im Wartungszustand ein Aufladen des Energiespeichers bei im Vergleich zum Normalzustand gleicher Stromrichtung an den Ausgangsanschlüssen zu ermöglichen.

Weiterhin ist die erfindungsgemäße Schutzschaltung in der Lage, in einem Sicherheitsfall, beispielsweise einem Brandfall, das an den Eingang der Schutzschaltung angeschlossene PV-Modul vom Ausgang der Schutzschaltung zu trennen und bewirkt somit eine Freischaltung des entsprechenden PV-Moduls, bei der eine Energieabgabe des PV-Moduls verhindert wird. Zu diesem Zweck wird der erste Schalter dauerhaft geöffnet und somit ein Eingangsanschluss von dem ihm zugeordneten Ausgangsanschluss dauerhaft getrennt. Der Energiespeicher wird im Sicherheitsfall, i.e. bei dauerhaft geöffnetem ersten Schalter, über die Eingangsanschlüsse und somit über das eingangsseitig an die Schutzschaltung angeschlossene PV-Modul aufgeladen.

Aufgrund der geringen Bauteilanzahl ist die Schutzschaltung extrem einfach und kostengünstig herstellbar. Durch die Energieversorgung einerseits über die Eingangsanschlüsse und andererseits über die Ausgangsanschlüsse ist die Schutzschaltung bei verschiedenen Zuständen des PV-Moduls, beispielsweise dem Normalzustand bei MPP Betrieb, dem verschatteten Zustand, wie auch dem Wartungszustand des PV-Moduls - dort sogar bei nicht angeschlossenem PV-Modul - einsetzbar. Die Schutzschaltung ermöglicht gleichfalls in einem Sicherheitsfall eine Freischaltung des an den Eingang angeschlossenen PV-Moduls. Auf diese Weise lässt sich bei einer PV-Anlage, bei der zumindest einzelne PV-Module - beziehungsweise eine ausreichende Anzahl von PV-Modulen - einer Serienschaltung von PV-Modulen eine erfindungsgemäße Schutzschaltung aufweisen, eine Spannung von Verbindungsleitungen zwischen der Serienschaltung von PV-Modulen und einem PV-Wechselrichter der PV-Anlage unterhalb eines gefährdungskritischen Spannungswertes halten.

In einer Ausführungsform der erfindungsgemäßen Schutzschaltung ist der erste Schalter in einer Verbindungsleitung zwischen einem einem positiven Pol des PV-Moduls zugeordneten Eingangsanschluss und dem diesem Eingangsanschluss zugeordneten positiven Ausgangsanschluss angeordnet. Bei dieser Anordnung des ersten Schalters ist eine Anode der ersten Diode mit einer Anode der zweiten Diode über den Mittelpunkt der Serienschaltung aus erster Diode und Energiespeicher verbunden. In einer alternativen Ausführungsform der erfindungsgemäßen Schutzschaltung ist der erste Schalter in einer Verbindungsleitung zwischen einem einem negativen Pol des PV-Moduls zugeordneten Eingangsanschluss und dem diesem Eingangsanschluss zugeordneten negativen Ausgangsanschluss angeordnet. Bei dieser Anordnung des ersten Schalters ist eine Kathode der ersten Diode mit einer Kathode der zweiten Diode über den Mittelpunkt der Serienschaltung aus erster Diode und Energiespeicher verbunden. Hierbei kennzeichnen die Begriffe "positiver Pol" bzw. "negativer Pol" des PV-Moduls den jeweils bei einer Leerlaufspannung des PV-Moduls "positiven" bzw. "negativen" Pol des PV-Moduls.

In einer Ausführungsform der Schutzschaltung ist die Anode der ersten Diode mit dem dem positiven Pol des PV-Moduls zugeordneten Eingangsanschluss verbunden. In diesem Fall ist ein Anschluss des Energiespeichers mit einem dem negativen Pol des PV-Moduls zugeordneten Eingangsanschluss verbunden, während der andere Anschluss des Energiespeichers mit der Kathode der ersten Diode verbunden ist. In einer alternativen Ausführungsform der Schutzschaltung ist die Kathode der ersten Diode mit dem dem negativen Pol des PV-Moduls zugeordneten Eingangsanschluss verbunden. Dabei ist ein Anschluss des Energiespeichers mit einem dem positiven Pol des PV-Moduls zugeordneten Eingangsanschluss verbunden, während der andere Anschluss des Energiespeichers mit der Anode der ersten Diode verbunden ist. Beide Ausführungsformen der Schutzschaltung weisen eine Durchflussrichtung der ersten Diode auf, die eine Aufladung des Energiespeichers über die Eingangsanschlüsse bei ausreichend hoher Eingangsspannung Uₑᵢₙ ermöglichen, jedoch gleichzeitig eine Entladung des Energiespeichers bei einem Absinken der Eingangsspannung Uₑᵢₙ über die Eingangsanschlüsse vermeiden. Insbesondere wird in beiden Ausführungsformen eine Entladung des Energiespeichers bei negativer Eingangsspannung Uₑᵢₙ < 0 unterdrückt. Somit kann nahezu die gesamte einmal in den Energiespeicher geflossene Energie wunschgemäß zur Versorgung der Steuerung und gegebenenfalls weiterer Komponenten der Schutzschaltung verwendet werden und eine unerwünschte Dissipation von einmal gespeicherter Energie wird vermieden.

Vorteilhafterweise weist der Energiespeicher einen Kondensator, einen Superkondensator und/oder einen Akkumulator auf. Sofern der Energiespeicher eine Kombination des Kondensators und des Akkumulators beziehungsweise des Superkondensator und des Akkumulators aufweist, ist der Akkumulator parallel mit dem Kondensator bzw. dem Superkondensator verschaltet. Vorteilhafterweise kann der Energiespeicher eine Schaltung zur Spannungsstabilisierung beziehungsweise Spannungsbegrenzung, beispielsweise eine Z-Diode oder einen Längsregler aufweisen, die dem Energiespeicher vorgeschaltet oder nachgeschaltet sein kann. Dabei verhindert eine dem Energiespeicher vorgeschaltete Spannungsbegrenzung ein Aufladen des Energiespeichers über einen kritischen Wert hinaus und begrenzt somit die über dem Energiespeicher abfallende Ladespannung U_{ES} auf einen vorgegebenen Wert. Eine nachgeschaltete Spannungsstabilisierung beziehungsweise Spannungsbegrenzung erlaubt zwar eine Aufladung des Energiespeichers bis zu einem Wert nahe der Eingangsspannung Uₑᵢₙ, ist jedoch zwischen Energiespeicher und einem an diesen angeschlossenen Verbraucher, beispielsweise der Steuerung geschaltet. In jedem Fall, i. e. einer vorgeschalteten oder nachgeschalteten Spannungsbegrenzung, wird verhindert, dass der Verbraucher bei Versorgung über den Energiespeicher eine Spannung erfährt, die zu einer Funktionsbeeinträchtigung oder Schädigung des jeweiligen Verbrauchers führt.

Prinzipiell ist als erster Schalter sowohl ein elektromechanischer Schalter als auch ein Halbleiterschalter möglich. In einer vorteilhaften Ausführungsform der Schutzschaltung weist der erste Schalter einen Halbleiterschalter auf. Bei dem Halbleiterschalter handelt es sich vorteilhafterweise um einen MOSFET (Metal-Oxide-Semiconductor-Field-Effect-Transistor). So ist beispielsweise ein MOSFET relativ zu einem IGBT (Insulated-Gate-Bipolar-Transistor) als Halbleiterschalter bzw. ersten Schalter durch einen geringeren Wert des Durchgangswiderstandes gekennzeichnet. Hierdurch wird bei geschlossenem ersten Schalter die über dem ersten Schalter abfallende Verlustleistung minimiert. Auf diese Weise kann eine notwendige Kühlung des ersten Schalters relativ einfach und kostengünstig ausgeführt werden, wenn nicht gänzlich entfallen. Ein im Vergleich zu einem IGBT geringerer Wert der Sperrspannung eines MOSFET's kann dabei toleriert werden, wenn innerhalb einer Serienschaltung von PV-Modulen eine ausreichende Anzahl der PV-Module eine erfindungsgemäße Schutzschaltung aufweisen. Auf diese Weise wird die zu sperrende Spannung auf die Anzahl der innerhalb der Serienschaltung von PV-Modulen vorhandenen MOSFETs aufgeteilt.

In einer Ausführungsform umfasst die erfindungsgemäße Schutzschaltung weiterhin einen Bypasspfad parallel zum Eingang der Schutzschaltung. Dabei weist der Bypasspfad optional eine dritte Diode auf, die mit ihrer Anode mit dem dem negativen Pol des PV-Modules zugeordneten Eingangsanschluss der Schutzschaltung, und mit ihrer Kathode mit dem dem positiven Pol des PV-Modules zugeordneten Eingangsanschluss der Schutzschaltung verbunden ist. Somit ist in diesem Fall der Bypasspfad auch bei einem nicht an die Schutzschaltung angeschlossenen PV-Modul ein integraler Bestandteil der Schutzschaltung selbst. Vorteilhafterweise ist er zusammen mit den anderen Komponenten der Schutzschaltung innerhalb eines gemeinsamen Gehäuses der Schutzschaltung angeordnet. Der Bypasspfad muss daher bei einer Entfernung des PV-Moduls - z.B. bei einem Wartungszustand - nicht erst separat erzeugt werden. Dies erhöht zwar geringfügig die Herstellungskosten der Schutzschaltung, verringert jedoch in einem Wartungsfall den erforderlichen Aufwand und kann hierdurch überkompensiert werden.

Für den Fall, dass die Schutzschaltung den Bypasspfad umfasst, kann der Bypasspfad einen zweiten Schalter aufweisen, der über die Steuerung der Schutzschaltung ansteuerbar ist. Dabei kann der Bypasspfad sowohl lediglich den zweiten Schalter, nicht aber die dritte Diode, oder auch den zweiten Schalter in Kombination mit der dritten Diode aufweisen. Prinzipiell ist als zweiter Schalter auch ein elektromechanischer Schalter möglich. Vorteilhafterweise umfasst der zweite Schalter jedoch einen Halbleiterschalter. Für den Fall, dass der Bypasspfad sowohl den zweiten Schalter als auch die dritte Diode aufweist, ist es besonders vorteilhaft - weil kostengünstig - wenn der zweite Schalter ein MOSFET (Metal-Oxide-Semiconductor-Field-Effect-Transistor) ist, wobei insbesondere die dritte Diode des Bypasspfades durch eine intrinsische Diode des MOSFET's gebildet wird. Bedarfsweise kann so bei einem Stromfluss durch den Bypasspfad der MOSFET aufgesteuert werden, wodurch die Verlustleistung im Bypasspfad drastisch reduziert wird. Weil nun erfindungsgemäß die Versorgung der Steuerung immer gewährleistet ist, kann die Kühlung auf diese reduzierte Verlustleistung ausgelegt werden, wodurch Kosten gespart werden. Über den zweiten Schalter kann das eingangsseitig an die Schutzschaltung angeschlossene PV-Modul kurzgeschlossen werden. Auf diese Weise kann bei einem Sicherheitsfall die innerhalb einer PV-Anlage auftretende Gleichspannung zusätzlich verringert werden. Indem beispielsweise der erste Schalter der Schutzschaltung dauerhaft geöffnet ist und der zweite Schalter vorwiegend geschlossen ist, kann die an den Eingangsanschlüssen anliegende Eingangsspannung Uₑᵢₙ sogar nahezu bei 0V gehalten werden. In diesem Fall ist lediglich ein wiederholtes kurzzeitiges Öffnen des zweiten Schalters notwendig, um den Energiespeicher wieder aufzuladen. Innerhalb einer Serienschaltung mehrerer eine erfindungsgemäße Schutzschaltung aufweisenden PV-Module kann das Öffnen des zweiten Schalters jedoch zeitlich versetzt zueinander und möglichst ohne zeitlichen Überlapp untereinander erfolgen, wodurch im Sicherheitsfall die in der Serienschaltung auftretende Gleichspannung nochmals minimiert werden kann und eine zusätzliche Redundanz bereitgestellt wird, die auch im Fall eines fehlerhaften ersten Schalters eine Freischaltung des eingangsseitig angeschlossenen PV-Moduls gewährleistet.

Obwohl die Steuerung der Schutzschaltung prinzipiell auch vollständig in analoger Form realisierbar ist, weist die Steuerung der Schutzschaltung in einer vorteilhaften Ausführungsform einen Mikrocontroller µC auf.

In einer weiteren Ausführungsform weist die Schutzschaltung eine Kommunikationseinheit auf. Dabei ist die Kommunikationseinheit konfiguriert, ein externes Signal zur Ansteuerung des ersten Schalters und / oder des zweiten Schalters zu empfangen. Die Schutzschaltung befindet sich vorteilhafterweise in örtlicher Nähe zum PV-Modul. Durch die Kommunikationseinheit kann ein von einer übergeordneten zentralen Steuerungseinheit, beispielsweise einem Photovoltaik (PV) - Wechselrichter oder einer separaten Steuerungseinheit, erzeugtes externes Signal zur Ansteuerung des ersten Schalters und/oder des zweiten Schalters empfangen werden. Auf diese Weise können in Reaktion auf das empfangene externe Signal die ersten und/oder zweiten Schalter mehrerer Schutzschaltungen innerhalb einer Serienschaltung von PV-Modulen, die jeweils eine Schutzschaltung aufweisen, gezielt angesteuert werden.

Die Kommunikationseinheit ist in der Lage eine unidirektionale, vorteilhafterweise jedoch auch eine bidirektionale Kommunikation durchzuführen, wobei die Kommunikation grundsätzlich sowohl drahtlos, z.B. per Funk, als auch drahtgebunden erfolgen kann. In einer vorteilhaften Ausführungsform der Schutzschaltung ist die Kommunikationseinheit konfiguriert, eine Power-Line Kommunikation über eine an den Ausgangsanschluss angeschlossene Leitung zu ermöglichen. Dabei kann die Schutzschaltung optional einen zum Ausgang parallelen Pfad zum Aus- oder Einkopplen eines Power-Line Signals aufweisen. Vorteilhafterweise ist der Pfad parallel zum Ausgang für eine Kommunikationsfrequenz des Power-Line Signals niederimpedant ausgeführt und weist hierzu eine Serienschaltung einer Induktivität und eines Kondensators auf. Auf diese Weise ist gewährleistet, dass das Power-Line Signal selbst bei geöffnetem ersten Schalter vom ersten Ausgangsanschluss zum zweiten Ausgangsanschluss der Schutzschaltung gelangen kann, während ein Gleichstrom vom ersten zum zweiten Ausgangsanschluss verhindert wird. Somit wird auch die Power-Line Kommunikation innerhalb einer Serienschaltung mehrerer PV-Module, die eine erfindungsgemäße Schutzschaltung aufweisen, selbst bei freigeschalteten PV-Modulen ermöglicht.

Vorteilhafterweise weist eine einen Mikrocontroller µC und/oder eine Kommunikationseinheit aufweisende Schutzschaltung weiterhin zumindest eine der folgenden Komponenten auf:
- einen ersten Stromsensor zur Detektion eines in der Serienschaltung aus erster Diode und Energiespeicher zu dem Energiespeicher hinfließenden oder von dem Energiespeicher abfließenden Ladestroms I_{ES},
- einen zweiten Stromsensor zur Detektion eines zwischen dem PV-Modul und einem der Eingangsanschlüsse der Schutzschaltung fließenden Eingangsstroms Iₑᵢₙ,
- einen dritten Stromsensor zur Detektion eines zwischen einem der Ausgangsanschlüsse der Schutzschaltung und den an die Schutzschaltung angeschlossenen weiteren PV-Modulen fließenden Ausgangsstroms Iₐᵤₛ,
- einen ersten Spannungssensor zur Detektion einer über dem Energiespeicher abfallenden Ladespannung U_{ES},
- einen zweiten Spannungssensor zur Detektion einer zwischen den Eingangsanschlüssen der Schutzschaltung anliegenden Eingangsspannung Uₑᵢₙ,
- einen dritten Spannungssensor zur Detektion einer zwischen den Ausgangsanschlüssen der Schutzschaltung anliegenden Ausgangsspannung Uₐᵤₛ und
- einen vierten Spannungssensor zur Detektion einer über den ersten Schalter abfallenden Schalterspannung U_{S1}.

Damit ist die Schutzschaltung in der Lage, selbsttätig bestimmte Zustände des an die Schutzschaltung angeschlossenen PV-Moduls, beispielsweise einen Normalzustand, einen Verschattungszustand, und/oder einen Wartungszustand des PV-Moduls zu detektieren. In Reaktion auf den detektierten Zustand und/oder in Reaktion auf ein externes Signal kann die Schutzschaltung somit selbsttätig Schalthandlungen des ersten und/oder des zweiten Schalters durchführen. Vorteilhafterweise ist die Schutzschaltung dabei derart konfiguriert, den ersten Schalter und/oder den zweiten Schalter in Abhängigkeit zumindest eines detektierten Wertes aus:
- Ladestrom I_{ES},
- Eingangsstrom Iₑᵢₙ,
- Aussgangsstrom Iₐᵤₛ,
- Ladespannung U_{ES},
- Eingangsspannung Uₑᵢₙ,
- Ausgangsspannung Uₐᵤₛ, und
- Schalterspannung U_{S1}
anzusteuern. Dabei ist die Schutzschaltung, insbesondere deren Steuerung, auch in der Lage die Werte miteinander zu kombinieren, eine Kombination dieser Werte auszuwerten und die Schalter entsprechend der ausgewerteten Kombination anzusteuern. Gleichfalls kann die Schutzschaltung konfiguriert sein, den ersten und/oder den zweiten Schalter in Abhängigkeit des von der Kommunikationseinheit empfangenen Signals anzusteuern.

Ein Verfahren zum Betrieb einer Schutzschaltung ist gekennzeichnet durch die durchgeführten Schritte:
- Versorgen der Steuerung der Schutzschaltung mit elektrischer Energie aus dem Energiespeicher, wobei
- die Schutzschaltung in einem ersten Betriebszustand betrieben wird, solange die an den Eingangsanschlüssen anliegende Eingangsspannung Uₑᵢₙ innerhalb eines ersten Wertebereiches liegt, wobei in dem ersten Betriebszustand ein Laden des Energiespeichers über die Eingangsanschlüsse bei dauerhaft geschlossenem ersten Schalter erfolgt; und wobei
- die Schutzschaltung in einem zweiten Betriebszustand betrieben wird, solange die an den Eingangsanschlüssen anliegende Eingangsspannung Uₑᵢₙ innerhalb eines zweiten Wertebereiches liegt, wobei in dem zweiten Betriebszustand ein Laden des Energiespeichers über die Ausgangsanschlüsse durch ein wiederholtes temporäres Öffnen des ersten Schalters erfolgt; und wobei
- die Schutzschaltung bei Vorliegen vordefinierter Rahmenbedingungen zusätzlich in einem dritten Betriebszustand betrieben wird, bei dem der erste Schalter dauerhaft geöffnet ist, wobei in dem dritten Betriebszustand ein Laden des Energiespeichers über die Eingangsanschlüsse erfolgt. Auch in dem dritten Betriebszustand erfolgt somit das Laden des Energiespeichers ähnlich zum ersten Betriebszustand über das eingangsseitig an die Schutzschaltung angeschlossene PV-Modul.

Dabei ist der erste Betriebszustand der Schutzschaltung insbesondere dem Normalzustand des an die Schutzschaltung angeschlossenen PV-Moduls zugeordnet, bei dem das PV-Modul in einem Arbeitspunkt maximaler Leistung (MPP = Maximum Power Point) betrieben wird. Der zweite Betriebszustand der Schutzschaltung wird insbesondere dann eingenommen, wenn das an die Schutzschaltung angeschlossene PV-Modul einen Verschattungszustand und/oder einen Wartungszustand aufweist. Indem das PV-Modul einen Wartungszustand aufweist, kann der zweite Betriebszustand der Schutzschaltung auch dann eingenommen werden, wenn kein PV-Modul eingangsseitig an die Schutzschaltung angeschlossen ist. Gegebenenfalls sind in diesem Fall die Eingangsanschlüsse der Schutzschaltung über einen separaten Bypasspfad gebrückt, insbesondere dann, wenn die Schutzschaltung selbst diesen Bypasspfad als einen integralen Bestandteil der Schutzschaltung nicht umfasst. Der dritte Betriebszustand der Schutzschaltung ist einem Sicherheits- oder Gefahrenfall zugeordnet, während dessen eine Freischaltung des eingangsseitig an die Schutzschaltung angeschlossenen PV-Moduls erwünscht ist.

Die eine Höhe der Eingangsspannung Uₑᵢₙ charakterisierenden Wertebereiche, d.h. der erste Wertebereich und der zweite Wertebereich, sind als Intervalle zu verstehen und können entweder direkt aneinander angrenzen, oder aber voneinander beabstandet sein. So können der erste und der zweite Wertebereich beispielsweise über einen dritten Wertebereich so voneinander beabstandet sein, dass der erste Wertebereich an den dritten Wertebereich angrenzt, der seinerseits wieder an den zweiten Wertebereich angrenzt. Dabei kann ein Betriebszustand, der bei einer in dem dritten Wertebereich liegenden Eingangsspannung Uₑᵢₙ eingenommen wird, jeweils davon abhängen, welcher Betriebszustand zuvor eingenommen wurde und dem jeweils zuvor angenommenen Betriebszustand entsprechen. Auf diese Weise kann ein hystereseartiger Wechsel von dem ersten Betriebszustand in den zweiten Betriebszustand und umgekehrt realisiert werden.

Mit einem Öffnen des ersten Schalters - gegebenenfalls auch des zweiten Schalters - ist im Rahmen der Anmeldung einerseits ein vollständiges Öffnen des jeweiligen Schalters gekennzeichnet. Zusätzlich umfasst der Begriff Öffnen im Sinne der vorliegenden Anmeldung jedoch auch ein teilweises - und somit nicht vollständiges - Öffnen des entsprechenden Schalters und ist insbesondere bei Verwendung eines Halbleiterschalters als ersten und/oder zweiten Schalter von Bedeutung. So kann bei einem Halbleiterschalter, insbesondere bei einem MOSFET, ein Öffnen des Schalters gewissermaßen graduell unter Erhöhung des ohmschen Widerstandes des Schalters erfolgen. Auf diese Weise kann das Öffnen des Halbleiterschalters auch so erfolgen, dass die über den Schalter abfallende Schalterspannung - beispielsweise U_{S1} - gesteuert wird, insbesondere konstant gehalten wird, oder einem vordefinierten Verlauf folgt.

Sofern die Schutzschaltung einen Bypasspfad mit einem zweiten Schalter umfasst, kann während des Betreibens der Schutzschaltung im zweiten Betriebszustand der zweite Schalter zur Verringerung einer Verlustleistung dauerhaft geschlossen werden. So kann aufgrund einer Reduktion der Verlustleistung der Aufwand zur Kühlung des zweiten Schalters minimiert werden. Der Begriff Schließen umfasst im Rahmen der vorliegenden Anmeldung auch ein zumindest teilweises Schließen, bei dem ein ohmscher Widerstand des zweiten Schalters lediglich verringert, insbesondere graduell verringert wird. Auf diese Weise kann der zweite Schalter die Funktion einer aktiven Bypassdiode während eines Verschattungszustandes des eingangsseitig an die Schutzschaltung angeschlossenen PV-Moduls übernehmen.

Sofern die Schutzschaltung einen Bypasspfad mit einem zweiten Schalter umfasst, kann dann, wenn die Schutzschaltung in dem dritten Betriebszustand betrieben wird, die Eingangsspannung Uₑᵢₙ an den Eingangsanschlüssen der Schutzschaltung durch ein Schließen des zweiten Schalters unterhalb eines zweiten Grenzwertes gehalten werden. Konkret kann somit die Eingangsspannung Uₑᵢₙ an den Eingangsanschlüssen der Schutzschaltung für einen Großteil einer Zeitdauer, während der die Schutzschaltung in dem dritten Betriebszustand betrieben wird, unterhalb des zweiten Grenzwertes gehalten werden. In diesem Fall wird der zweite Schalter lediglich zum Laden des Energiespeichers wiederholt temporär, d.h. kurzzeitig geöffnet. Eine in einem Sicherheitsfall auftretende Spannung eines PV-Modules kann damit nahezu auf 0V reduziert werden. Weiterhin resultiert aus einem Abtrennen des PV-Moduls aufgrund eines geöffneten ersten Schalters in Verbindung mit einem Kurzschluss des PV-Moduls aufgrund des geschlossenen zweiten Schalters eine redundante Sicherheit während der Freischaltung des entsprechenden PV-Moduls.

In einer Ausführungsform des Verfahrens weisen die vordefinierten Rahmenbedingungen, bei deren Vorliegen die Schutzschaltung in dem dritten Betriebszustand betrieben wird, ein von der Schutzschaltung empfangenes Signal, oder ein Ausbleiben eines von der Schutzschaltung zuvor empfangenen Signals auf. Als Signal ist hier insbesondere ein regelmäßig wiederholt gesendetes Signal, ein sogenanntes Keep-Alive Signal zu verstehen. Es ist jedoch auch möglich, dass die Schutzschaltung durch ein charakteristisches Signal in den dritten Zustand versetzt und/oder aus diesem heraus versetzt wird. Dabei ist es möglich, dass ansonsten weder in dem ersten Betriebszustand noch in dem zweiten Betriebszustand ein Signal in wiederholter Art und Weise gesendet wird. Dabei kann das Signal von einer übergeordneten zentralen Steuerungseinheit, beispielsweise einem Photovoltaik (PV) - Wechselrichter, sowohl drahtlos - z.B. per Funk - als auch drahtgebunden - z.B. über eine Power-Line Kommunikation - der Schutzschaltung beziehungsweise deren Kommunikationseinheit übermittelt werden.

In einer Ausführungsform des Verfahrens erfolgt das wiederholte temporäre Öffnen des ersten Schalters im zweiten Betriebszustand oder das wiederholte temporäre Öffnen des zweiten Schalters im dritten Betriebszustand bei Unterschreiten eines unteren Schwellwertes der über dem Energiespeicher abfallenden Ladespannung U_{ES}. Dabei dauert der geöffnete Zustand jeweils an, bis die über dem Energiespeicher abfallende Ladespannung U_{ES} einen oberen Schwellwert übersteigt. Hieraus resultiert ein sägezahnartiger zeitlicher Verlauf der Ladespannung U_{ES}, dessen Amplitude nach oben hin durch den oberen Schwellwert und nach unten hin durch den unteren Schwellwert begrenzt ist. Der zeitliche Verlauf der Ladespannung U_{ES} ähnelt damit dem einer Zwei-Punkt-Regelung. In einer alternativen Ausführungsform des Verfahrens erfolgt das wiederholte temporäre Öffnen des ersten Schalters im zweiten Betriebszustand oder das wiederholte temporäre Öffnen des zweiten Schalters im dritten Betriebszustand in Form einer getakteten Ansteuerung des jeweiligen Schalters mit einem Tastgrad. Dabei wird der Tastgrad in Abhängigkeit einer aktuell über den Energiespeicher abfallenden Ladespannung U_{ES} bestimmt. Eine Öffnungsdauer des jeweiligen Schalters und damit ein Ladezyklus wird umso größer gewählt, je kleiner die über den Energiespeicher abfallende Ladespannung U_{ES} ist. Auch hier ergibt sich - zumindest auf einer mikroskopischen Zeitskala betrachtet - ein sägezahnartiger Verlauf der über den Energiespeicher abfallenden Ladespannung U_{ES}. Die Ladespannung U_{ES} selbst lässt sich jedoch aufgrund einer üblicherweise hohen Taktfrequenz feiner regeln, beziehungsweise in einem engeren Toleranzbereich halten.

In einer vorteilhaften Ausführungsform des Verfahrens weist ein Übergang der Schutzschaltung in den dritten Betriebszustand zumindest einen der folgenden Schritte auf:
- Betreiben des ersten Schalters für eine erste Zeitdauer in einem in Abhängigkeit der über dem ersten Schalter abfallenden Schalterspannung U_{S1} geregelten Linearbetrieb,
- Betreiben des ersten Schalters für eine zweite Zeitdauer in einem Linearbetrieb bei einer über dem ersten Schalter abfallenden zeitlich ansteigenden Schalterspannung U_{S1},
- Verschieben eines Arbeitspunktes des an die Schutzschaltung angeschlossenen PV-Moduls oder aller PV-Module der Serienschaltung von PV-Modulen in Richtung einer Leerlaufspannung der PV-Module über einen an die Serienschaltung von PV-Modulen angeschlossenen Photovoltaik (PV) - Wechselrichter und Herbeiführen einer damit verbundenen Leistungsreduktion der Serienschaltung von PV-Modulen.

Generell ist es vorteilhaft, den ersten Schalter beim Übergang in den dritten Betriebszustand in einem möglichst lastfreien Zustand, zumindest jedoch in einem möglichst lastreduzierten Zustand vollständig zu öffnen. Indem der erste Schalter nun für eine erste Zeitdauer in einem in Abhängigkeit der über dem ersten Schalter abfallenden Schalterspannung U_{S1} geregelten Linearbetrieb betrieben wird, kann eine Leistungsreduktion der Serienschaltung von PV-Modulen herbeigeführt werden, ohne dass der erste Schalter oberhalb seiner Sperrspannung und/oder oberhalb seiner Maximaltemperatur belastet und dadurch beschädigt wird. Dabei kann der geregelte Linearbetrieb konkret das Ziel verfolgen, die über dem ersten Schalter abfallende Schalterspannung U_{S1} auf einen konstanten Wert zu regeln. Auf diese Weise können so innerhalb der ersten Zeitdauer die ersten Schalter mehrerer bzw. aller Schutzschaltungen innerhalb der Serienschaltung der PV-Module auch mit geringem Zeitversatz zueinander öffnen und in kollektiver Weise die Leistungsreduktion der Serienschaltung der PV-Module unterstützen, ohne dass ein einzelner erster Schalter oder mehrere einzelne erste Schalter dabei beschädigt werden. Dabei ist die über dem ersten Schalter abfallende konstante Schalterspannung U_{S1} einerseits möglichst hoch gewählt, um eine möglichst rasche Leistungsreduktion zu bewirken. Andererseits ist sie jedoch in jedem Fall unterhalb einer erlaubten Sperrspannung des ersten Schalters gewählt. Zusätzlich ist bei der Wahl der konstanten Schalterspannung U_{S1} auch zu berücksichtigen, dass eine Temperaturbelastung des ersten Schalters innerhalb der ersten Zeitdauer stets unterhalb einer für den ersten Schalter kritischen Temperaturbelastung gehalten wird und somit eine Beschädigung des ersten Schalters vermieden wird. In ähnlicher Weise und mit den ähnlichen Randbedingungen bewirkt auch eine über dem ersten Schalter abfallende zeitlich ansteigende Schalterspannung U_{S1} eine entsprechende Leistungsreduktion der Serienschaltung der PV-Module.

Indem ein Arbeitspunkt des an die Schutzschaltung angeschlossenen PV-Moduls oder aller PV-Module der Serienschaltung von PV-Modulen in Richtung einer Leerlaufspannung der PV-Module verschoben wird, erfolgt ebenfalls eine Leistungsreduktion der Serienschaltung der PV-Module. In diesem Fall wird die Leistungsreduktion jedoch über einen an die Serienschaltung von PV-Modulen angeschlossenen Photovoltaik (PV) - Wechselrichter herbeigeführt.

Sofern die Schutzschaltung einen Bypasspfad mit einem zweiten Schalter S₂ umfasst, weist ein vorteilhaftes Verfahren bei einem Übergang der Schutzschaltung in den dritten Betriebszustand die folgenden Schritte auf:
- Herbeiführen einer Leistungsreduktion der Serienschaltung von PV-Modulen, vor einem Öffnen des ersten Schalters, wobei
- das Herbeiführen der Leistungsreduktion ein Schließen des zweiten Schalters der Schutzschaltung oder ein Schließen der zweiten Schalter mehrerer Schutzschaltungen von PV-Modulen innerhalb der Serienschaltung von PV-Modulen aufweist.

Über ein Schließen des zweiten Schalters der Schutzschaltung oder ein Schließen der zweiten Schalter mehrerer Schutzschaltungen von PV-Modulen innerhalb der Serienschaltung von PV-Modulen wird bei einer konstant gehaltenen Zwischenkreisspannung eines PV-Wechselrichters, an den die Serienschaltung von PV-Modulen angeschlossen ist, ebenfalls eine Leistungsreduktion der Serienschaltung von PV-Modulen herbeigeführt. Konkret wird ein Arbeitspunkt des eingangsseitig an die Schutzschaltung angeschlossenen PV-Moduls bei einem Schließen des zweiten Schalters der Schutzschaltung in Richtung eines Kurzschlusses des PV-Moduls verschoben. Die Arbeitspunkte der weiteren PV-Module, bei deren Schutzschaltung der zweite Schalter noch nicht geschlossen ist, werden so in Richtung ihrer Leerlaufspannung verschoben. In beiden Fällen erfolgt eine Leistungsreduktion der einzelnen PV-Module der Serienschaltung von PV-Modulen. Hierbei ist jedoch darauf zu achten, dass, wenn jedem PV-Modul der Serienschaltung von PV-Modulen eine Schutzschaltung zugeordnet ist, nicht die zweiten Schalter aller Schutzschaltungen geschlossen werden. In diesem Fall würde nämlich ein Zwischenkreis des PV-Wechselrichters kurzgeschlossen. Konkret sollte hier der zweite Schalter zumindest einer, gegebenenfalls auch mehrerer Schutzschaltungen geöffnet bleiben.

In einer vorteilhaften Ausführungsform wird die Leistungsreduktion beim Übergang in den dritten Betriebszustand derart herbeigeführt, dass ein Schließen des zweiten Schalters der Schutzschaltung oder ein Schließen der zweiten Schalter mehrerer Schutzschaltungen von PV-Modulen innerhalb der Serienschaltung von PV-Modulen nicht abrupt, sondern zeitlich gestreckt erfolgt. Dabei wird der jeweilig zu schließende zweite Schalter beim Übergang von dem geöffneten in den geschlossenen Zustand während einer dritten Zeitdauer, die um ein Vielfaches größer als eine minimale Schaltdauer des zweiten Schalters ist, in einem Linearbetrieb mit zeitlich abnehmendem ohmschen Widerstand betrieben. Zusätzlich wird innerhalb der dritten Zeitdauer, gegebenenfalls auch noch zeitlich danach, der Ausgangsstrom oder ein Parameter, der einen Rückschluss auf den Ausgangsstrom zulässt, detektiert. Die Detektion verfolgt das Ziel, einen Zeitpunkt zu ermitteln, bei dem der Ausgangsstrom Null ist, oder sich ausgehend von einem vorwärts gerichteten Ausgangsstrom ein Ausgangsstrom in Rückwärtsrichtung ausbildet. Mit einem Strom in Rückwärtsrichtung ist dabei ein Rückstrom innerhalb der Serienschaltung von PV-Modulen gemeint. Vorteilhafterweise wird nun der erste Schalter der Schutzschaltung - beziehungsweise es werden die ersten Schalter mehrerer Schutzschaltungen innerhalb der Reihenschaltung von PV-Modulen - dann geöffnet, wenn ein Betrag des Ausgangsstrom einen Stromschwellwert unterschreitet. Indem der Betrag des Ausgangsstroms den Stromschwellwert unterschreitet, kann von einem lastfreien, zumindest jedoch lastreduzierten Zustand innerhalb der Serienschaltung der PV-Module ausgegangen werden. Ist hingegen auch nach erfolgtem Schließen eines zweiten Schalters auch weiterhin ein Ausgangsstrom in Vorwärtsrichtung oberhalb des Stromschwellwertes vorhanden, so ist noch keine ausreichende Leistungsreduktion der Serienschaltung von PV-Modulen erreicht. In diesem Fall wird der erste Schalter noch nicht geöffnet und es wird weiterhin der Ausgangsstrom beobachtet. In diesem Fall können nun weitere zweite Schalter der Schutzschaltungen innerhalb der Serienschaltung von PV-Modulen aufeinanderfolgend und jeweils zeitlich gestreckt geschlossen werden. Auf diese Weise wird mit jedem Schließen eines weiteren zweiten Schalters - bei ansonsten gleicher Spannungsdifferenz zwischen den Enden der Serienschaltung von PV-Modulen, die über einen an die Serienschaltung angeschlossenen Wechselrichters kontrolliert werden kann - die Leistung und insbesondere der Strom der Serienschaltung von PV-Modulen schrittweise reduziert. Der Strom innerhalb der Serienschaltung von PV-Modulen entspricht dem detektierten Ausgangsstrom in den entsprechenden Schutzschaltungen. Die schrittweise Reduktion wird solange fortgeführt, bis der detektierte Ausgangsstrom den Stromschwellenwert unterschreitet. Bei Unterschreitung des Stromschwellenwertes wird der erste Schalter der Schutzschaltung beziehungsweise werden die ersten Schalter der Schutzschaltungen innerhalb der Serienschaltung von PV-Modulen geöffnet.

Eine erfindungsgemäße Photovoltaik (PV)-Anlage weist einen PV-Wechselrichter mit zumindest einer an den PV-Wechselrichter angeschlossen Serienschaltung von PV-Modulen auf. Dabei weist zumindest eines der PV-Module eine erfindungsgemäße Schutzschaltung auf. Vorteilhafterweise weisen mehrere PV-Module der Serienschaltung die erfindungsgemäße Schutzschaltung auf. Dabei kann deren Anzahl so gewählt sein, dass eine innerhalb der Serienschaltung der PV-Module auftretende Spannung im Gefahrenfall stets unterhalb einer maximal erlaubten Spannung gehalten wird. Dabei ist zu berücksichtigen, dass eine Summe von Sperrspannungen der insgesamt in der Serienschaltung der PV-Module verbauten ersten Schalter stets größer ist als die Leerlaufspannung der Serienschaltung der PV-Module. In einer Ausführungsform weisen alle PV-Module der Serienschaltung die erfindungsgemäße Schutzschaltung auf.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen - insbesondere der dargestellten relativen Anordnung und Wirkverbindung mehrerer Bauteile - zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Merkmale können durch andere Merkmale ergänzt werden oder die einzigen Merkmale sein, aus denen das jeweilige Erzeugnis besteht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

### KURZBESCHREIBUNG DER FIGUREN

Im Folgenden wird die Erfindung anhand in den Figuren dargestellter bevorzugter Ausführungsbeispiele weiter erläutert und beschrieben.
- **Fig. 1a**: zeigt eine erste Ausführungsform der erfindungsgemäßen Schutzschaltung;
- **Fig. 1b**: zeigt eine zweite Ausführungsform der erfindungsgemäßen Schutzschaltung;
- **Fig. 2a**: illustriert schematisch einen Stromverlauf während des ersten Betriebszustandes am Beispiel einer dritten Ausführungsform der Schutzschaltung;
- **Fig. 2b**: illustriert schematisch einen Stromverlauf während des zweiten Betriebszustandes am Beispiel der dritten Ausführungsform der Schutzschaltung aus Fig. 2a;
- **Fig. 2c**: illustriert schematisch einen Stromverlauf der Schutzschaltung während des dritten Betriebszustandes am Beispiel der dritten Ausführungsform der Schutzschaltung aus Fig. 2a;
- **Fig. 3**: zeigt zeitliche Verläufe von Schaltzuständen des ersten und des zweiten Schalters und entsprechende zeitliche Verläufe einzelner elektrischer Größen während des zweiten Betriebszustandes am Beispiel der Schutzschaltung aus Fig. 2a.
- **Fig. 4**: zeigt zeitliche Verläufe von Schaltzuständen des ersten und des zweiten Schalters und entsprechende zeitliche Verläufe einzelner elektrischer Größen während des dritten Betriebszustandes der Schutzschaltung aus Fig. 2a.
- **Fig. 5**: zeigt ein Ablaufdiagramm eines erfindungsgemäßen Verfahrens zum Betrieb der Schutzschaltung aus Fig. 2a

### FIGURENBESCHREIBUNG

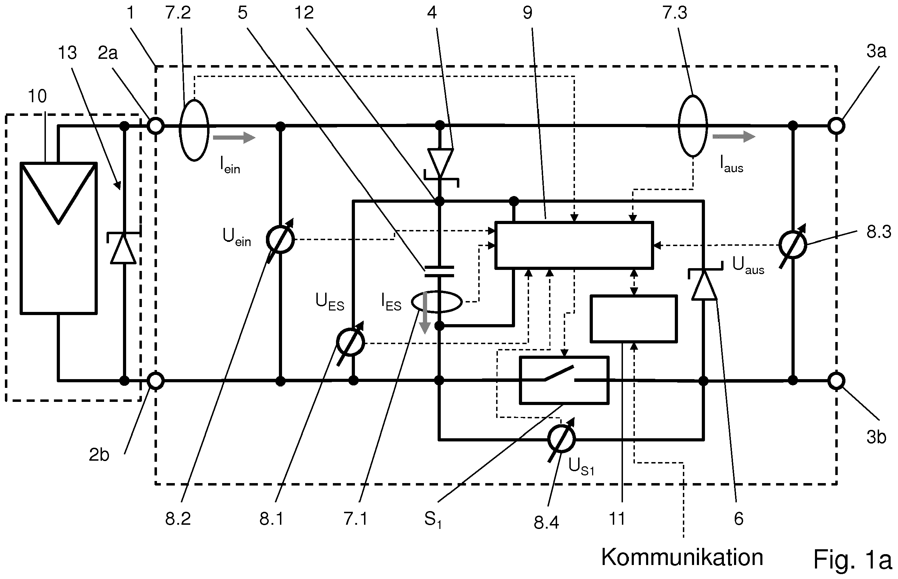

Die **Fig. 1a** zeigt den Aufbau einer ersten Ausführungsform einer erfindungsgemäßen Schutzschaltung 1. Die Schutzschaltung 1 weist einen Eingang mit zwei Eingangsanschlüssen 2a, 2b zum Anschluss eines PV-Moduls 10 und einen Ausgang mit zwei Ausgangsanschlüssen 3a, 3b zum Anschluss weiterer PV-Module 10 einer Serienschaltung von PV-Modulen 10. Dabei können einzelne, gegebenenfalls auch alle der weiteren PV-Module 10 der Serienschaltung ebenfalls eine derartige Schutzschaltung 1 aufweisen. Ein einem positiven Pol des PV-Moduls 10 zugeordneter Eingangsanschluss 2a ist direkt mit einem ersten Ausgangsanschluss 3a der Schutzschaltung verbunden, während ein einem negativen Pol des PV-Moduls 10 zugeordneter Eingangsanschluss 2b über einen ersten Schalter S₁ mit einem zweiten Ausgangsanschluss 3b verbunden ist. Der erste Schalter S₁ wird über eine Steuerung 9 angesteuert, was über einen gestrichelten Pfeil symbolisiert ist. Die Steuerung 9 wird über einen Energiespeicher, hier dargestellt in Form eines Kondensators 5, versorgt. Der Kondensator ist in Serie mit einer ersten Diode 4 verschaltet, wobei die Serienschaltung aus erster Diode 4 und Kondensator 5 parallel zum Eingang der Schutzschaltung geschaltet ist. Weiterhin weist die Schutzschaltung eine zweite Diode 6 auf, die anodenseitig mit dem zweiten Ausgangsanschluss 3b und kathodenseitig mit einem Mittelpunkt 12 der Serienschaltung aus erster Diode 4 und Kondensator 5 verbunden ist. Dabei ist die erste Diode 4 in Bezug auf ihre Durchlassrichtung so orientiert, dass ihre Kathode mit der Kathode der zweiten Diode 6 verbunden ist. Die Schutzschaltung 1 weist weiterhin eine Kommunikationseinheit 11 auf, die in der Lage ist ein Kommunikationssignal zu empfangen. Dabei ist die Kommunikationseinheit 11 derart konfiguriert, das Kommunikationssignal drahtgebunden, z. B. über eine Power-Line Kommunikation über an die Ausgangsanschlüsse 3a, 3b angeschlossene Leitungen zu empfangen. Alternativ dazu kann die Kommunikationseinheit jedoch auch konfiguriert sein, das Kommunikationssignal drahtlos, z. B. per Funk, zu empfangen.

Mit der Steuerung 9 sind verschiedene Strom- und Spannungssensoren verbunden, welche Verbindungen ebenfalls durch gestrichelte Pfeile symbolisiert sind. Ein erster Stromsensor 7.1 misst einen über den Kondensator 5 als Energiespeicher fließenden Lade- bzw. Entladestrom I_{ES}. Ein zweiter Stromsensor 7.2 misst einen von dem PV-Modul 10 über einen der Eingangsanschlüsse 2a, 2b - hier den dem positiven Pol des PV-Moduls 10 zugeordneten Eingangsanschluss 2a - fließenden Eingangsstrom Iₑᵢₙ. Ein dritter Stromsensor 7.3 misst einen über einen der Ausgangsanschlüsse 3a, 3b - hier dem ersten Ausgangsanschluss 3a - zu den benachbarten PV-Modulen 10 der ausgangsseitig an die Schutzschaltung angeschlossenen Serienschaltung von PV-Modulen 10 fließenden Ausgangsstrom Iₐᵤₛ. Ein erster Spannungssensor 8.1 misst eine über den Kondensator 5 als Energiespeicher abfallende Ladespannung U_{ES}, die als Maß für den Ladezustand des Energiespeichers dient. Ein zweiter Spannungssensor 8.2 misst eine an den Eingangsanschlüssen 2a, 2b anliegende Eingangsspannung Uₑᵢₙ. Im Falle eines Normalzustandes des angeschlossenen PV-Modules 10 ist diese positiv, d.h. Uₑᵢₙ = U(2a) - U(2b) > 0, und entspricht üblicherweise der MPP Spannung des eingangsseitig angeschlossenen PV-Moduls 10. In einem Verschattungszustand des entsprechenden PV-Modules 10 ist die Eingangsspannung Uₑᵢₙ negativ, d.h. Uₑᵢₙ = U(2a) - U(2b) < 0. Ein dritter Spannungssensor 8.3 misst die an den Ausgangsanschlüssen 3a, 3b anliegende Ausgangsspannung Uₐᵤₛ. In dem ersten Betriebszustand der Schutzschaltung 1, bei dem der erste Schalter S₁ dauerhaft geschlossen ist, sind die Eingangsanschlüsse 2a, 2b der Schutzschaltung 1 mit den zugeordneten Ausgangsanschlüssen 3a, 3b niederimpedant verbunden und die Eingangsspannung Uₑᵢₙ ist im Wesentlichen gleich der Ausgangsspannung Uₐᵤₛ. Ein vierter Spannungssensor 8.4 misst eine über den ersten Schalter S₁ abfallende Schalterspannung U_{S1}. Die Steuerung 9 weist einen Mikrocontroller µC auf und ist ausgelegt, den ersten Schalter S₁ in Abhängigkeit zumindest eines detektierten Parameters aus der Gruppe: Ladestrom I_{ES}, Eingangsstrom Iₑᵢₙ, Ausgangsstrom Iₐᵤₛ, Ladespannung U_{ES}, Eingangsspannung Uₑᵢₙ, Ausgangsspannung Uₐᵤₛ und Schalterspannung U_{S1} oder einer Kombination hieraus anzusteuern. Gleichfalls ist die Steuerung 9 ausgelegt, den ersten Schalter S₁ in Abhängigkeit des von der Kommunikationseinheit 11 empfangenen Kommunikationssignales anzusteuern.

An die Schutzschaltung 1 gemäß Fig. 1a ist eingangsseitig parallel zu dem PV-Modul 10 ein externer Bypasspfad 13 in Form einer inhärent mit dem PV-Modul 10 verbundenen Bypassdiode angeschlossen. Dies ist in Fig. 1a durch ein gestrichelt gezeichnetes Rechteck um beide Bauteile symbolisiert. Die Schutzschaltung 1 umfasst in dieser Ausführungsform keinen Bypasspfad 13 als integralen Bestandteil der Schutzschaltung 1 selbst.

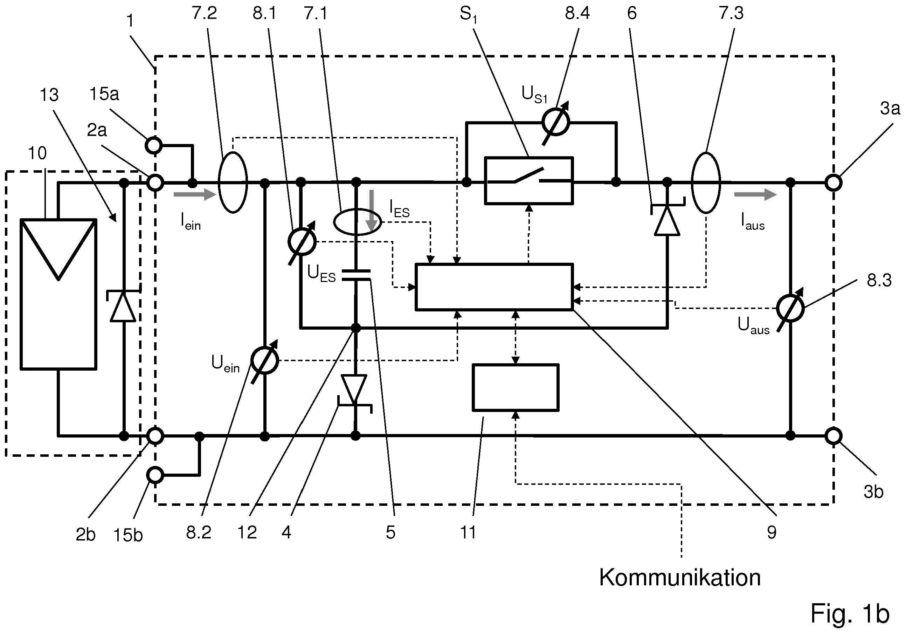

**Fig. 1b** zeigt eine alternative zweite Ausführungsform der erfindungsgemäßen Schutzschaltung 1. In vielen Details entspricht diese der bereits unter Fig. 1a beschriebenen ersten Ausführungsform und es wird diesbezüglich auf die entsprechenden Ausführungen der Beschreibung zur Fig. 1a verwiesen. An dieser Stelle werden daher vielmehr die Unterschiede der zweiten Ausführungsform gegenüber der ersten Ausführungsform beschrieben.

Im Gegensatz zur Schutzschaltung 1 gemäß Fig. 1a ist in der Ausführungsform gemäß Fig. 1b der erste Schalter S₁ zwischen dem dem positiven Pol des PV-Moduls zugeordnetem Eingangsanschluss 2a und dem entsprechenden ersten Ausgangsanschluss 3a angeordnet. Die Serienschaltung aus Kondensator 5 und erster Diode 4 ist hier in ihrer Reihenfolge vertauscht parallel zum Eingang der Schutzschaltung 1 angeschlossen. Dabei ist jedoch die Durchflussrichtung der ersten Diode 4 relativ zur Polarität des an die Schutzschaltung 1 angeschlossenen PV-Modules 10 unverändert. In beiden Fällen - Fig. 1a und Fig. 1b - ermöglicht die Durchflussrichtung der ersten Diode 4 eine Aufladung des Kondensators 5 über die Eingangsanschlüsse 2a, 2b bei ausreichend hoher positiver Eingangsspannung Uₑᵢₙ, verhindert jedoch dessen unerwünschte Entladung über die Eingangsanschlüsse 2a, 2b bei negativer Eingangsspannung Uₑᵢₙ < 0. Die zweite Diode 6 ist in Fig. 1b anodenseitig über den Mittelpunkt 12 der Serienschaltung aus erster Diode 4 und Kondensator 5 mit der Anode der ersten Diode 4 und kathodenseitig mit dem ersten Ausgangsanschluss 3a verbunden. In beiden Fällen - Fig. 1a und Fig. 1b - ist eine Serienschaltung aus Kondensator 5 und zweiter Diode 6 parallel zum ersten Schalter S₁ geschaltet und ermöglicht somit einen elektrischen Pfad, auf den ein zuvor über den geschlossenen ersten Schalter S₁ fließender Strom beim Öffnen des ersten Schalters S₁ kommutieren kann.

Zusätzlich zur Fig. 1a weist die Schutzschaltung 1 gemäß Fig. 1b zwei zusätzliche an ein Gehäuse der Schutzschaltung 1 herausgeführte Eingangsanschlüsse 15a, 15b auf. Die zusätzlichen Eingangsanschlüsse 15a, 15b können beispielsweise mit einer Drahtbrücke verbunden werden, wenn im Wartungsfall das PV-Modul 10 mit der dem PV-Modul 10 inhärent zugeordneten Bypassdiode als Bypasspfad 13 entfernt wird, um auch bei nicht vorhandenem PV-Modul 10 einen elektrischen Pfad vom ersten Ausgangsanschluss 3a über den ersten Schalter S₁ zum zweiten Ausgangsanschluss 3b zu gewährleisten.

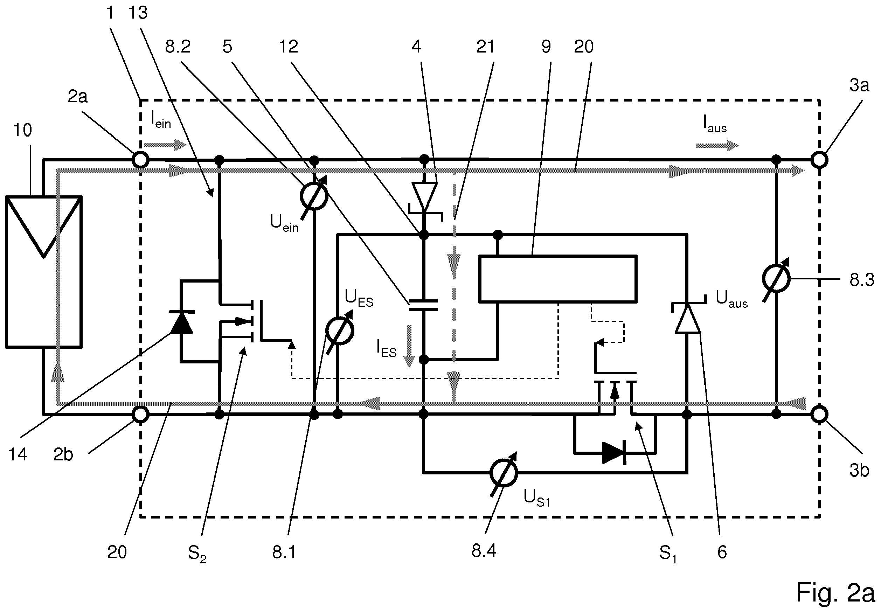

**Fig. 2a** zeigt einen Stromverlauf während des ersten Betriebszustandes der Schutzschaltung 1 am Beispiel einer dritten Ausführungsform der Schutzschaltung 1. Der Übersichtlichkeit halber sind hier lediglich die Spannungssensoren 8.1, 8.2, 8.3, 8.4 nicht aber die Stromsensoren 7.1, 7.2, 7.3 dargestellt. Zusätzlich ist die Kommunikationseinheit 11 der Übersichtlichkeit halber nicht dargestellt. Nichtsdestoweniger können die in Fig. 2a nicht dargestellten Komponenten jedoch trotzdem vorhanden sein. Auch die dritte Ausführungsform weist Gemeinsamkeiten mit der ersten Ausführungsform gemäß Fig. 1a auf und es wird in Bezug auf diese Gemeinsamkeiten auf die entsprechenden Ausführungen unter der Beschreibung zur Fig. 1a verwiesen.

Im Gegensatz zu der Fig. 1a umfasst die Ausführungsform in Fig. 2a nun einen Bypasspfad 13 als integralen Bestandteil der Schutzschaltung 1. Hierzu ist der Bypasspfad 13 beispielsweise in einem gemeinsamen Gehäuse zusammen mit weiteren Komponenten der Schutzschaltung 1 angeordnet. Der Bypasspfad 13 umfasst eine dritte Diode 14 und einen Halbleiterschalter, hier einen MOSFET, als zweiten Schalter S₂. Im Fall des MOSFET's kann die dritte Diode 14 durch eine Body Diode des MOSFET's verkörpert werden. Gleichfalls ist es jedoch möglich, dass der Bypasspfad 13 auch eine separate dritte Diode 14 aufweist, insbesondere dann, wenn es sich bei dem Halbleiterschalter als zweiten Schalter S₂ nicht um einen MOSFET handelt. Auch der erste Schalter S₁ ist in dieser Ausführungsform als MOSFET ausgeführt. Sowohl der erste Schalter S₁ als auch der zweite Schalter S₂ sind durch die Steuerung 9 ansteuerbar. Parallel zu den Ausgangsschlüssen kann in der dritten Ausführungsform der Schutzschaltung 1, wie auch in den vorherigen Ausführungsformen, ein für ein Wechselstrom-Signal als Kommunikationssignal - z.B. ein Power Line Signal - niederimpedanter Pfad geschaltet sein. Dieser ist aus Gründen der Übersichtlichkeit in Fig. 2a nicht dargestellt. Der niederimpedante Pfad weist eine Serienschaltung aus Induktivität und Kondensator auf und gewährleistet, dass ein an dem einen Ausgangsanschluss 3a, 3b ankommendes Kommunikationssignal die Schutzschaltung 1 auch bei geöffnetem ersten Schalter S₁ zum jeweils anderen Ausgangsanschluss 3b, 3a passieren kann. Dabei ist der niederimpedante Pfad nur für das Wechselstrom-Signal, d.h. das Kommunikationssignal, niederimpedant, während er für einen Gleichstrom hochimpedant bzw. undurchlässig ist.

In dem ersten Betriebszustand befindet sich das an die Schutzschaltung 1 angeschlossene PV-Modul 10 in einem Normalzustand und wird im MPP Arbeitspunkt der maximalen Leistung, zumindest jedoch in dessen Nähe, betrieben. Die Eingangsspannung Uₑᵢₙ ist hier positiv, Uₑᵢₙ > 0, und im Wesentlichen gleich der MPP Spannung. Der erste Schalter S₁ ist dauerhaft geschlossen und stellt so einen niederimpedanten Pfad zwischen dem zweiten Ausgangsanschluss 3b und dem dem negativen Pol des PV-Moduls 10 zugeordneten Eingangsanschluss 2b bereit. Der zweite Schalter S₂ ist in dem ersten Betriebszustand dauerhaft geöffnet. In einem dem ersten Betriebszustand zugeordneten Stromverlauf fließt ein Strom 20 über den zweiten Ausgangsanschluss 3b, den ersten Schalter S₁, über den dem negativen Pol zugeordneten Eingangsanschluss 2b, das PV-Modul 10, über den dem positiven Pol des PV-Moduls 10 zugeordneten Eingangsanschluss 2a und über den ersten Ausgangsanschluss 3a. Dabei fließt ein geringer Teilstrom 21 über die Serienschaltung aus erster Diode 4 und Energiespeicher, hier in Form des Kondensators 5 - und lädt diesen auf. In dem ersten Betriebszustand erfolgt die Aufladung des Kondensators 5 durch den Teilstrom 21 nahezu kontinuierlich, sofern die Höhe der Eingangsspannung Uₑᵢₙ dies zulässt. Zum Schutz der zwecks Versorgung an den Energiespeicher - hier den Kondensator 5 - angeschlossenen Verbraucher, insbesondere der Steuerung 9, kann der Energiespeicher weiterhin Mittel zur Spannungsstabilisierung beziehungsweise zur Spannungsbegrenzung, wie z.B. Z-Dioden, Längsregler oder Querregler aufweisen. Diese sind aus Gründen der Übersichtlichkeit in Fig. 2a nicht dargestellt.

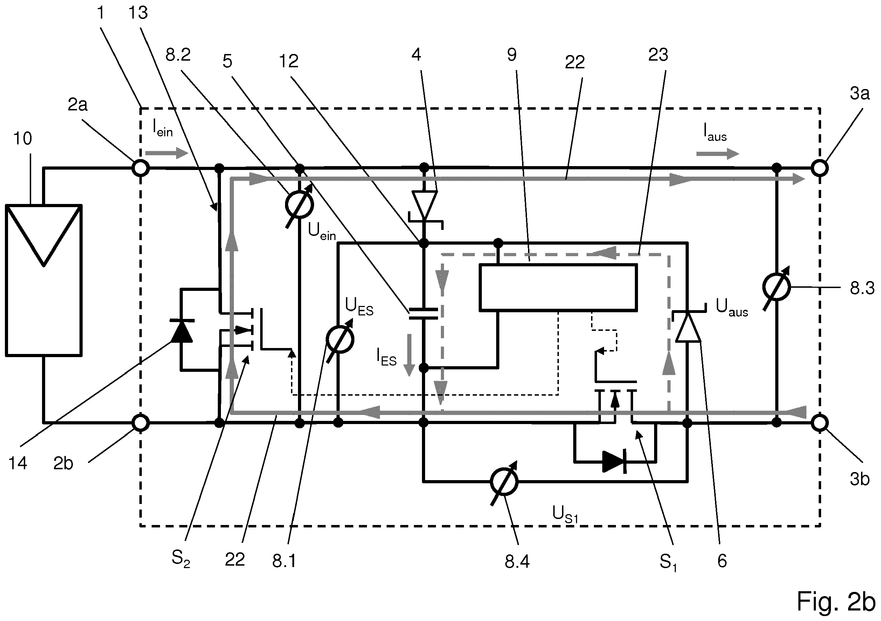

In **Fig. 2b** ist der Stromverlauf während des zweiten Betriebszustandes, der beispielsweise während eines Verschattungszustandes oder eines Wartungszustandes des eingangsseitig an die Schutzschaltung 1 angeschlossenen PV-Moduls 10 eingenommen wird, dargestellt. Grundlage der Darstellung ist die bereits in Fig. 2a gezeigte dritte Ausführungsform der Schutzschaltung 1.

Im Verschattungszustand des PV-Moduls 10 ist die Eingangsspannung Uₑᵢₙ negativ, Uₑᵢₙ < 0. In diesem Betriebszustand ist der zweite Schalter S₂ dauerhaft geschlossen und stellt somit über den Bypasspfad 13 eine niederimpedante Verbindung zwischen den Eingangsanschlüssen 2a, 2b bereit. Auch der erste Schalter S₁ ist zeitmäßig betrachtet vorwiegend geschlossen. Er wird lediglich zur Aufladung des Energiespeichers, hier des Kondensators 5, wiederholt temporär - d.h. kurzzeitig - geöffnet und danach wieder geschlossen. Im geöffneten Zustand kommutiert ein zuvor über den ersten Schalter S₁ fließender Strom 22 auf die zum ersten Schalter S₁ parallel geschaltete Serienschaltung aus zweiter Diode 6 und Energiespeicher, hier in Form des Kondensators 5. Für diesen kurzen Zeitraum betrachtet ergibt sich somit ein Teilstrom 23, der den Kondensator 5 als Energiespeicher auflädt. Bei dem Teilstrom 23 kann es sich, je nachdem, wie weit der erste Schalter S₁ geöffnet wurde, d.h. welcher ohmsche Durchgangswiderstand über ihn entstanden ist, um den gesamten oder nur um einen Bruchteil des zuvor über den ersten Schalter S₁ fließenden Stroms 22 handeln. Zur Unterscheidung beider Strompfade ist in Fig. 2b der Teilstrom 23 gestrichelt dargestellt, während der Strom 22 durchgezogen illustriert ist.

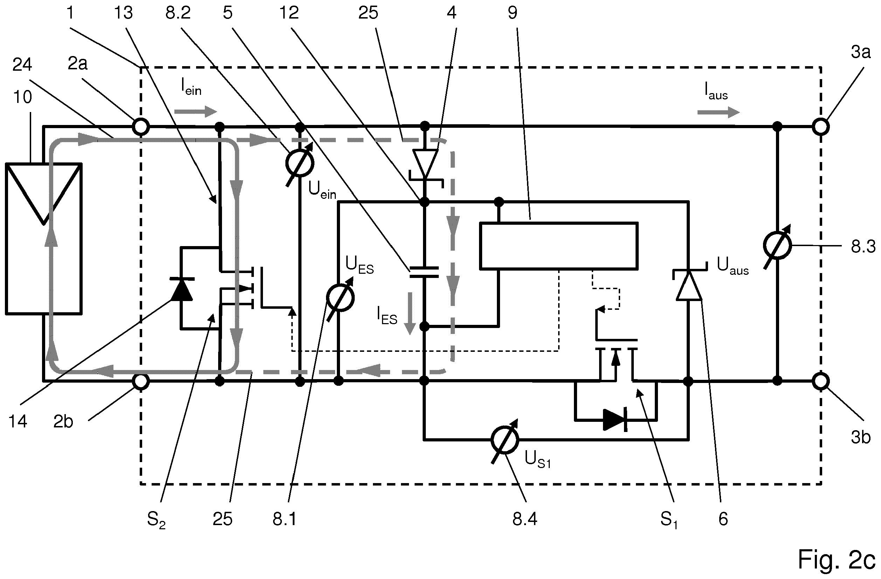

In **Fig. 2c** ist der Stromverlauf während des dritten Betriebszustandes der Schutzschaltung 1, der beispielsweise während eines Sicherheits- oder Gefahrenfalles eingenommen wird, dargestellt. Grundlage der Darstellung ist auch hier die bereits in Fig. 2a gezeigte dritte Ausführungsform der Schutzschaltung 1. Der dritte Betriebszustand wird von der Schutzschaltung 1 lediglich bei vordefinierten Rahmenbedingungen eingenommen, und wird daher der Schutzschaltung geeignet signalisiert. Diese Signalisierung kann beispielsweise über ein Ausbleiben eines zuvor regelmäßig an den Ausgangsanschlüssen 3a, 3b der Schutzschaltung 1 anliegendes und von der Kommunikationseinheit 11 empfangenes Power-Line Signal erfolgen.

Beim Betrieb der Schutzschaltung 1 in dem dritten Betriebszustand ist der erste Schalter S₁ dauerhaft geöffnet und eine Energieabgabe des PV-Moduls 10 von den Eingangsanschlüssen 2a, 2b zu den Ausgangsanschlüssen 3a, 3b wird verhindert. Zusätzlich ist der zweite Schalter S₂ der Schutzschaltung zeitmäßig betrachtet vorwiegend geschlossen und schließt somit das an den Eingang angeschlossene PV-Modul 10 kurz. Auf diese Weise entsteht eine redundante Sicherheit, da einerseits aufgrund einer nahezu bei 0V liegenden Eingangsspannung Uₑᵢₙ ≈ 0V als auch über eine Trennung zwischen Eingang und Ausgang der Schutzschaltung eine Energieabgabe des PV-Moduls 10 verhindert wird. In dem dritten Betriebszustand fließt ein Kurzschlussstrom 24 des PV-Moduls 10 über die Eingangsanschlüsse 2a, 2b und den zweiten Schalter S₂. Da sich aufgrund des Energieverbrauchs der Steuerung 9 der Kondensator 5 als Energiespeicher langsam entlädt, muss dieser wieder aufgeladen werden. Eine Aufladung des Kondensators 5 erfolgt im dritten Betriebszustand durch ein wiederholtes temporäres Öffnen des zweiten Schalters S₂. Während der zweite Schalter S₂ geöffnet ist, fließt ein zuvor über den zweiten Schalter S₂ fließender Teilstrom 25 nun über die Serienschaltung aus erster Diode 4 und Kondensator 5 zurück zum PV-Modul 10. Über diesen Teilstrom 25 wird der Kondensator 5 als Energiespeicher wieder aufgeladen. Der während des geöffneten Zustandes des zweiten Schalters S₂ auftretende Anstieg der Eingangsspannung Uₑᵢₙ wie auch die Zeitdauer des geöffneten Zustandes des zweiten Schalters S₂ können hier auf sehr kleinen Werten gehalten werden. Zudem kann ein Öffnen der zweiten Schalter S₂ einer Serienschaltung von PV-Modulen 10 mit entsprechenden Schutzschaltungen 1 zeitlich versetzt zueinander erfolgen. Hierdurch kann die selbst bei einem Fehlerfall der ersten Schalter S₁ insgesamt an den Enden der Serienschaltung der PV-Module 10 auftretende Spannung, d.h. die Stringspannung, minimiert werden. Hierdurch kann auch das Risiko einer im Gefahrenfall nicht ordnungsgemäß erfolgten Freischaltung nochmals reduziert werden. In Fig. 2c ist der Teilstrom 25 gestrichelt dargestellt, während der im Kurzschlussfall fließende Strom 24 durchgezogen dargestellt ist.

In den Ausführungsformen der Figuren 1a, 1b, 2a, 2b und 2c ist der Energiespeicher exemplarisch als Kondensator 5 dargestellt. Alternativ oder kumulativ zu dem dargestellten Kondensator 5 kann der Energiespeicher jedoch auch einen Superkondensator und/oder einen Akkumulator umfassen.

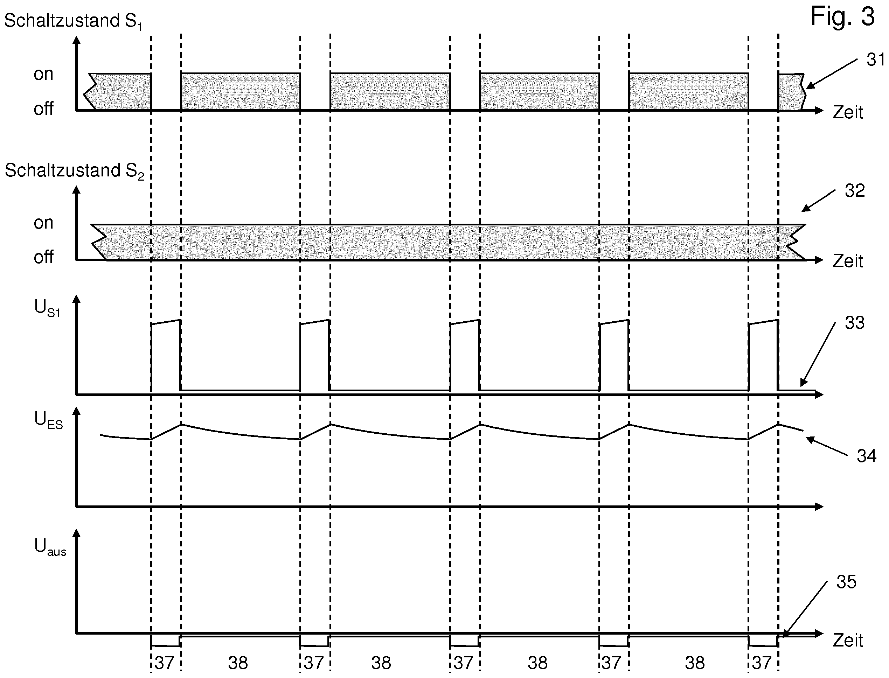

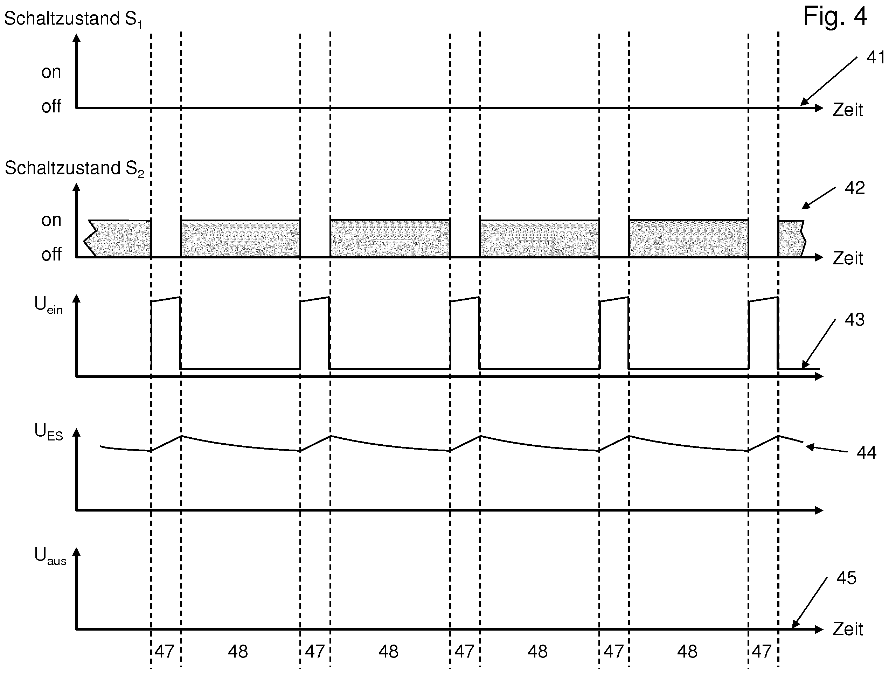

In **Fig. 3** sind zeitliche Verläufe von Schaltzuständen des ersten S₁ und des zweiten Schalters S₂ und sich daraus ergebende zeitliche Verläufe einzelner elektrischer Größen während des zweiten Betriebszustandes der Schutzschaltung 1 dargestellt. im Einzelnen sind dies: ein zeitlicher Verlauf 33 der über dem ersten Schalter S₁ abfallenden Schalterspannung U_{S1}, ein Verlauf 34 der über dem Kondensator 5 als Energiespeicher abfallenden Ladespannung U_{ES}, und ein Verlauf 35 der Ausgangsspannung Uₐᵤₛ. Die Beschreibungen zu Fig. 3 und Fig. 4 erfolgen exemplarisch unter Berücksichtigung der dritten Ausführungsform der Schutzschaltung 1 gemäß Fig. 2a.

Während des zweiten eine Verschattung bzw. einen Wartungszustand des PV-Moduls 10 kennzeichnenden Betriebszustandes der Schutzschaltung 1 ist der zweite Schalter S₂, wie in dem entsprechenden Verlauf 32 dargestellt, durchgängig geschlossen. Der erste Schalter S₁ ist zeitlich betrachtet vorwiegend, d.h. über eine lange Zeitdauer 38 geschlossen und lediglich während einer kurzen Zeitdauer 37 geöffnet. Dabei muss das Öffnen des MOSFETs als ersten Schalter S₁ nicht wie dargestellt, vollständig erfolgen. Vielmehr ist es ausreichend, wenn der erste Schalter S₁ lediglich so weit geöffnet wird, dass aufgrund des ansteigenden ohmschen Widerstandes zwischen seinen Drain und Source Kontakten ein hinreichend großer Teilstrom 23 des Stromes 22 über die parallel zum ersten Schalter S₁ angeordnete Serienschaltung aus zweiter Diode 6 und Kondensator 5 geführt wird. In der kurzen Zeitdauer 37 ist daher ein angehobener Wert der Schalterspannung U_{S1} zu beobachten, während die Schalterspannung U_{S1} während der längeren Zeitdauern 38, innerhalb derer der erste Schalter S₁ vollständig geschlossen ist, auf einen kleinen und üblicherweise vernachlässigbaren Wert abfällt. Während der kurzen Zeitdauern 37 wird der Kondensator 5 durch den über ihn fließenden Teilstrom 23 aufgeladen und es ergibt sich dort ein Anstieg im Verlauf 34 der über dem Kondensator 5 abfallenden Ladespannung U_{ES}. In den längeren Zeitdauern 38 hingegen ergibt sich aufgrund des Verbrauches der Steuerung 9 und ggf. weiterer an den Kondensator 5 angeschlossener Verbraucher ein stetiger Abfall der Ladespannung U_{ES}. Hieraus resultiert der in Fig. 3 dargestellte sägezahnartige beziehungsweise dreieckartige Verlauf 34 der Ladespannung U_{ES}. Der zeitliche Verlauf 35 der Ausgangsspannung Uₐᵤₛ der Schutzschaltung 1 ist innerhalb der längeren Zeitdauern 38, während derer der erste Schalter S₁ geschlossen ist, aufgrund des durchgängig geschlossenen zweiten Schalters S₂ auf einen betragsmäßig sehr geringen negativen Wert festgelegt. Lediglich innerhalb der kurzen Zeitdauern 37, während derer der erste Schalter S₁ geöffnet ist, spiegelt die Ausgangsspannung Uₐᵤₛ in etwa den inversen Wert der über dem Kondensator 5 abfallenden Ladespannung U_{ES} wider. Aufgrund eines relativ geringen Durchgangswiderstandes des MOSFET's als zweiten Schalter S₂ ist an diesem nur eine geringe Verlustleistung abzuführen und ein Aufwand zur Kühlung des zweiten Schalters S₂ kann gering und einfach gehalten werden, wenn nicht sogar gänzlich entfallen. Gleiches gilt bei entsprechend kurzen Zeitdauern 37 und/oder gering gehaltenen Schalterspannungen U_{S1} auch für den als MOSFET ausgeführten ersten Schalter S₁.

In **Fig. 4** sind zeitliche Verläufe 41, 42 von Schaltzuständen des ersten Schalters S₁ und des zweiten Schalters S₂ und sich daraus ergebende zeitliche Verläufe einzelner elektrischer Größen während des dritten Betriebszustandes der Schutzschaltung 1 dargestellt. Im Einzelnen ist in Fig. 4 der zeitliche Verlauf 33 der Eingangsspannung Uₑᵢₙ, der Verlauf 34 der über dem Kondensator 5 als Energiespeicher abfallenden Ladespannung U_{ES}, und der Verlauf 35 der Ausgangsspannung Uₐᵤₛ schematisch illustriert.

Im dritten Betriebszustand ist das PV-Modul 10 freigeschaltet und eine Energieabgabe desselben wird unterdrückt. Dabei erfolgt die Freischaltung vorliegend durch zwei redundante Maßnahmen, nämlich einen durchgängig vollständig geöffneten ersten Schalter S₁ zur Trennung des Ausgangs vom Eingang der Schutzschaltung 1 - vgl. zeitlicher Verlauf 41 - und einen vorwiegend geschlossenen zweiten Schalter S₂, der im geschlossenen Zustand - hier während der langen Zeitdauern 48 - das PV-Modul 10 zusätzlich kurzschließt. Der zweite Schalter S₂ wird, wie in dem entsprechenden zeitlichen Verlauf 42 dargestellt, lediglich wiederholt temporär, d.h. über kurze Zeitdauern 47 geöffnet. Während dieser Zeitdauern 47 wird ein Teilstrom 25 über die Serienschaltung aus erster Diode 4 und Kondensator 5 als Energiespeicher generiert, der den Kondensator 5 wieder auflädt. Entsprechend ergibt sich auch hier ein zur Fig. 3 ähnlicher, sägezahnartiger beziehungsweise dreieckartiger Verlauf der über den Energiespeicher abfallenden Ladespannung U_{ES}. Der Ausgang der Schutzschaltung 1 ist durchweg spannungsfrei, wie auch im Verlauf 45 der Ausgangsspannung Uₐᵤₛ dargestellt.

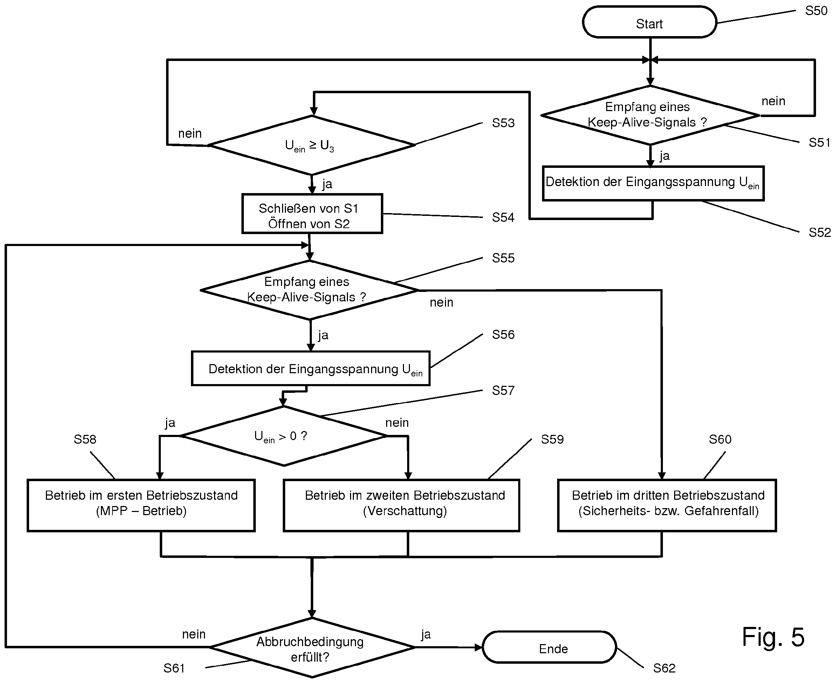

In **Fig. 5** ist ein Ablaufdiagramm eines erfindungsgemäßen Verfahrens zum Betrieb der Schutzschaltung 1 am Beispiel einer PV-Anlage mit einer Serienschaltung mehrerer PV-Module 10 dargestellt. Jedes der PV-Module 10 der Serienschaltung von PV-Modulen ist dabei an eine Schutzschaltung 1 angeschlossen. Die Schutzschaltungen 1 sind über ihre Ausgangsanschlüsse zur Bildung der Serienschaltung der mehreren PV-Module 10 verbunden. Jeweils ein Ausgangsanschluss der beiden äußeren Schutzschaltungen 1 ist mit einem DC-Eingangs eines PV-Wechselrichters verbunden, der wiederum zur Einspeisung erzeugter elektrischer Leistung mit einem Energieversorgungsnetz verbunden ist. Exemplarisch wird das Verfahren unter der Annahme, dass jede der Schutzschaltungen 1 gemäß Fig. 2a ausgelegt ist, dargestellt.

Das Verfahren startet mit einem Schritt S50, z.B. morgens bei einer durch den Sonnenaufgang festgelegten Uhrzeit. Zu dieser Zeit sind der erste Schalter S₁ und der zweite Schalter S₂ vollständig geöffnet. Nun wird in einem Schritt S51 geprüft, ob ein externes Signal, ein sogenanntes Keep-Alive Signal, von der Kommunikationseinheit 11 der Schutzschaltung 1 empfangen wird, wodurch ein einspeisebereiter Zustand der PV-Anlage signalisiert wird. Dabei kann das Keep-Alive Signal als externes Signal beispielsweise von einem PV-Wechselrichter im Rahmen einer Power-Line Kommunikation auf DC-Anschlussleitungen der Serienschaltung der PV-Module 10 aufgeprägt werden. Ist das Keep-Alive Signal nicht vorhanden, ist davon auszugehen, dass kein einspeisebereiter Zustand der PV-Anlage vorliegt. In diesem Fall wird zu einem späteren Zeitpunkt wiederholt geprüft, ob ein Empfang des Keep-Alive Signals erfolgt. Wird das Keep-Alive Signal mehrmals nicht detektiert, so kann dies als Abbruchbedingung interpretiert werden und das Verfahren kann vorzeitig beendet werden. Wird hingegen in dem Schritt S51 ein Keep-Alive Signal detektiert, so wird in einem Schritt S52 über den zweiten Spannungssensor 8.2 die Eingangsspannung Uₑᵢₙ der Schutzschaltung 1 gemessen, was in diesem Schalterzustand des ersten Schalters S₁ und des zweiten Schalters S₂ der Leerlaufspannung des PV-Moduls entspricht. In einem Schritt S53 wird geprüft, ob die Eingangsspannung Uₑᵢₙ größer oder gleich einem dritten Grenzwert U₃ ist, Uₑᵢₙ ≥ U₃. Ist dies nicht der Fall, so ist davon auszugehen, dass noch nicht ausreichend Einstrahlung vorhanden ist und das Verfahren springt zurück zu dem Schritt S51, der nach Ablauf einer Wartezeit wiederholt wird. Ist hingegen die Eingangsspannung Uₑᵢₙ größer oder gleich dem dritten Grenzwert U₃, Uₑᵢₙ ≥ U₃, so werden in einem Schritt S54 die ersten Schalter S₁ der Schutzschaltungen geschlossen. Damit werden die PV-Module 10 der Serienschaltung von PV-Modulen 10 miteinander verbunden und ein Stromfluss von einem PV-Modul 10 zum benachbarten PV-Modul 10 innerhalb der Serienschaltung von PV-Modulen 10 kann erfolgen. Der zweite Schalter S₂ wird vollständig geöffnet, sofern er nicht ohnehin schon vollständig geöffnet ist.

In einem Schritt S55 wird nun nochmals geprüft, ob das Keep-Alive Signal auch weiterhhin empfangen wird. Ist das Keep-Alive Signal auch weiterhin als externes Signal vorhanden, ist also die PV-Anlage weiterhin bereit zur Einspeisung, kann eine Energieabgabe des an die Schutzschaltung 1 angeschlossenen PV-Moduls 10 erfolgen.

Für die Energieabgabe springt das Verfahren nun zu einem Schritt S56, in dem nochmals die Eingangsspannung Uₑᵢₙ der Schutzschaltung 1 detektiert wird. Aus Gründen der Messgenauigkeit erfolgt diese Detektion vorteilhafterweise in einem Zustand der jeweiligen Schutzschaltung 1, bei dem der zweite Schalter S₂ geöffnet ist. Im dargestellten Fall sind die eine Höhe der Eingangsspannung Uₑᵢₙ charakterisierenden Wertebereiche so gewählt, dass der erste Wertebereich direkt an den zweiten Wertebereich angrenzt. Dabei ist der erste Wertebereich durch positive Werte der Eingangsspannungen Uₑᵢₙ (Uₑᵢₙ > 0) gekennzeichnet, während der zweite Wertebereich durch negative Werte der Eingangsspannungen Uₑᵢₙ (Uₑᵢₙ < 0) gekennzeichnet ist. Entsprechend wird in einem nachfolgenden Schritt S57 nun kontrolliert, ob die zuletzt detektierte Eingangsspannung Uₑᵢₙ positiv ist, d.h. ob gilt Uₑᵢₙ > 0. Ist dies der Fall, so kann von einem Normalzustand des entsprechenden PV-Moduls 10 ausgegangen werden und die Schutzschaltung 1 wird in einem Schritt S58 in dem ersten Betriebszustand betrieben. Der erste Betriebszustand kennzeichnet einen MPP-Betrieb des an die Schutzschaltung 1 angeschlossenen PV-Moduls 10. In dem ersten Betriebszustand ist der erste Schalter S₁ durchgängig geschlossen, während der zweite Schalter S₂ durchgängig geöffnet ist. Der Energiespeicher - hier der Kondensator 5 - wird über die Eingangsanschlüsse 2a, 2b geladen. Ist hingegen die Eingangsspannung negativ, d.h. gilt Uₑᵢₙ <0, so springt das Verfahren in einen Schritt S59, bei dem die Schutzschaltung im zweiten Betriebszustand betrieben wird. Dabei kennzeichnet der zweite Betriebszustand einen Verschattungszustand des an die Schutzschaltung 1 angeschlossenen PV-Moduls 10. Hier wird der zweite Schalter S₂ zur Minimierung der Verlustleistung vollständig geschlossen. Der erste Schalter S₁ ist zeitlich betrachtet ebenfalls vorwiegend geschlossen, wird jedoch zwecks Aufladung des Energiespeichers - hier des Kondensators 5 - wiederholt temporär geöffnet.

Wird hingegen in dem Schritt S55 das Keep-Alive Signal von der Kommunikationseinheit 11 der Schutzschaltung 1 nicht empfangen, so wird hierüber ein Sicherheits- bzw. Gefahrenfall der PV-Anlage signalisiert. In diesem Fall wechselt das Verfahren in einen Schritt S60, in dem die Schutzschaltung 1 in dem dritten, den Sicherheits- bzw. Gefahrenfall kennzeichnenden Betriebszustand betrieben wird. In diesem Betriebszustand wird das an die Schutzschaltung 1 angeschlossene PV-Modul 10 freigeschaltet und eine Energieabgabe desselben verhindert. Die Freischaltung erfolgt hier auf redundante Art und Weise, indem der erste Schalter S₁ durchgängig geöffnet betrieben wird und zusätzlich der zweite Schalter S₂ zeitlich betrachtet vorwiegend geschlossen betrieben. Lediglich zur Aufladung des Energiespeichers wird der zweite Schalter S₂ wiederholt temporär geöffnet.

In dem Schritt S61 wird wiederholt fortwährend überprüft, ob eine Abbruchbedingung zum Beenden des Verfahrens erfüllt ist. Ist dies nicht der Fall, so springt das Verfahren zurück zu dem Schritt S55, bei dem über den Empfang des Keep-Alive Signals signalisiert wird, ob die PV-Anlage auch weiterhin einspeisebereit ist bzw. ob ein Sicherheits- oder Gefahrenfall vorliegt. Über die Schleife in dem Ablaufdiagramm vom Schritt S61 zurück zu dem Schritt S55 ist das Verfahren auch in der Lage, von einem Betriebszustand zu einem jeweils anderen Betriebszustand zu wechseln. Dabei wird die Schleife solange durchlaufen, bis die Abbruchbedingung in dem Schritt S61 erfüllt ist. Danach wird das Verfahren in einem Schritt S62 beendet. Die Abbruchbedingung kann beispielsweise über das Erreichen einer bestimmten Tageszeit definiert sein, bei der von einem erfolgten Sonnenuntergang auszugehen ist. Alternativ dazu kann die Abbruchbedingung auch ein wiederholtes Auftreten eines nicht empfangenen Keep-Alive Signales aufweisen.

**BEZUGSZEICHENLISTE**

| | | |
|---|---|---|
| 1 | | Schutzschaltung |
| 2a, 2b | | Eingangsanschluss |
| 3a, 3b | | Ausgangsanschluss |
| 4 | | Diode |
| 5 | | Kondensator |
| 6 | | Diode |
| 7.1, 7.2, 7.3, 7.4 | | Stromsensor |
| 8.1, 8.2, 8.3, 8.4 | | Spannungssensor |
| 9 | | Steuerung |
| 10 | | PV-Modul |
| 11 | | Kommunikationseinheit |
| 12 | | Mittelpunkt |
| 13 | | Bypasspfad |
| 14 | | Diode |
| 15a, 15b | | Eingangsanschluss |
| 20, 22, 24 | | Strom |
| 21, 23, 35 | | Teilstrom |
| 31 - 35 | | zeitlicher Verlauf |
| 41 - 45 | | zeitlicher Verlauf |
| S50 - S62 | | Verfahrensschritt |
| | | |
| S₁, S₂ | | Schalter |
| Uₑᵢₙ | | Eingangsspannung |
| Uₐᵤₛ | | Ausgangsspannung |
| U_{ES} | | Ladespannung |
| U_{S1} | | Schalterspannung |
| Iₑᵢₙ | | Eingangsstrom |
| Iₐᵤₛ | | Ausgangsstrom |
| I_{ES} | | Ladestrom |
| I_{S1} | | Schalterstrom |
| µC | | Mikrocontroller |

## Patentansprüche

1. Schutzschaltung (1) für ein Photovoltaik (PV) - Modul (10), aufweisend
- einen Eingang mit zwei Eingangsanschlüssen (2a, 2b) zum Anschluss des PV-Moduls (10),
- einen Ausgang mit zwei Ausgangsanschlüssen (3a, 3b) zum Anschluss weiterer PV-Module (10) einer Serienschaltung von PV-Modulen (10),
- einen ersten Schalter (S₁) zur Verbindung eines der Eingangsanschlüsse (2a, 2b) mit einem der Ausgangsanschlüsse (3a, 3b), und
- eine Steuerung (9) konfiguriert zum Steuern des ersten Schalters (S₁),
- dass die Schutzschaltung (1) weiterhin eine Serienschaltung einer ersten Diode (4) und eines Energiespeichers aufweist, wobei die Serienschaltung parallel zum Eingang der Schutzschaltung (1) angeordnet ist,
- die Schutzschaltung (1) weiterhin eine zweite Diode (6) aufweist, die einen Ausgangsanschluss (3a, 3b) der Schutzschaltung (1) mit einem Mittelpunkt (12) der Serienschaltung aus erster Diode (4) und Energiespeicher verbindet, und
- **dadurch gekennzeichnet, dass**
eine Serienschaltung aus der zweiten Diode (6) und dem Energiespeicher parallel zu dem ersten Schalter (S₁) geschaltet ist.

2. Schutzschaltung (1) nach Anspruch 1, **dadurch gekennzeichnet, dass** eine Anode der ersten Diode (4) mit einer Anode der zweiten Diode (6) über den Mittelpunkt (12) der Serienschaltung aus erster Diode (4) und Energiespeicher verbunden ist, oder dass eine Kathode der ersten Diode (4) mit einer Kathode der zweiten Diode (6) über den Mittelpunkt (12) der Serienschaltung aus erster Diode (4) und Energiespeicher verbunden ist.

3. Schutzschaltung (1) nach Anspruch 1 oder 2, **dadurch gekennzeichnet, dass** die Anode der ersten Diode (4) mit dem einem positiven Pol des PV-Moduls (10) zugeordneten Eingangsanschluss (2a) verbunden ist oder dass die Kathode der ersten Diode (4) mit dem einem negativen Pol des PV-Moduls (10) zugeordneten Eingangsanschluss (2b) verbunden ist.

4. Schutzschaltung (1) nach einem der vorherigen Ansprüche, **dadurch gekennzeichnet, dass** die Schutzschaltung weiterhin einen Bypasspfad (13) parallel zum Eingang der Schutzschaltung (1) umfasst, wobei der Bypasspfad (13) optional eine dritte Diode (14) aufweist, die mit ihrer Anode mit dem dem negativen Pol des PV-Modules (10) zugeordneten Eingangsanschluss (2b) der Schutzschaltung (1), und mit ihrer Kathode mit dem dem positiven Pol des PV-Modules (10) zugeordneten Eingangsanschluss (2a) der Schutzschaltung (1) verbunden ist.

5. Schutzschaltung (1) nach Anspruch 4, **dadurch gekennzeichnet, dass** der Bypasspfad (13) einen zweiten Schalter (S₂) aufweist, der über die Steuerung (9) ansteuerbar ist.

6. Schutzschaltung (1) nach einem der vorherigen Ansprüche, **dadurch gekennzeichnet, dass** die Schutzschaltung (1) eine Kommunikationseinheit (11) aufweist, die konfiguriert ist, ein externes Signal zur Ansteuerung des ersten Schalters (S₁) und / oder, sofern der zweite Schalter (S₂) vorhanden ist, des zweiten Schalters (S₂) zu empfangen.

7. Schutzschaltung (1) nach Anspruch 6, **dadurch gekennzeichnet, dass** die Kommunikationseinheit (11) konfiguriert ist, eine Power-Line Kommunikation über eine an den Ausgangsanschluss (3a, 3b) angeschlossene Leitung zu ermöglichen, und wobei die Schutzschaltung (1) optional einen für ein Power-Line Signal niederimpedanten Pfad parallel zum Ausgang der Schutzschaltung (1) aufweist, wobei der Pfad eine Serienschaltung einer Induktivität und eines Kondensators aufweist.

8. Schutzschaltung (1) nach Anspruch 6 oder 7, **dadurch gekennzeichnet, dass** die Schutzschaltung (1) zumindest eine der folgenden Komponenten aufweist:
- einen ersten Stromsensor (7.1) zur Detektion eines in der Serienschaltung aus erster Diode (4) und Energiespeicher zu dem Energiespeicher hinfließenden oder von dem Energiespeicher abfließenden Ladestroms (I_{ES}),
- einen zweiten Stromsensor (7.2) zur Detektion eines zwischen dem PV-Modul (10) und einem der Eingangsanschlüsse (2a, 2b) der Schutzschaltung (1) fließenden Eingangsstroms (Iₑᵢₙ),
- einen dritten Stromsensor (7.3) zur Detektion eines zwischen einem der Ausgangsanschlüsse (3a, 3b) der Schutzschaltung (1) und den an die Schutzschaltung (1) angeschlossenen weiteren PV-Modulen (10) fließenden Ausgangsstroms (Iₐᵤₛ),
- einen ersten Spannungssensor (8.1) zur Detektion einer über dem Energiespeicher abfallenden Ladespannung (U_{ES}),
- einen zweiten Spannungssensor (8.2) zur Detektion einer zwischen den Eingangsanschlüssen (2a, 2b) der Schutzschaltung (1) anliegenden Eingangsspannung (Uₑᵢₙ),
- einen dritten Spannungssensor (8.3) zur Detektion einer zwischen den Ausgangsanschlüssen (3a, 3b) der Schutzschaltung anliegenden Ausgangsspannung (Uₐᵤₛ) und
- einen vierten Spannungssensor (8.4) zur Detektion einer über dem ersten Schalter (S₁) abfallenden Schalterspannung (U_{S1}) und wobei die Steuerung (9) konfiguriert ist, den ersten Schalter (S₁) und/oder, sofern der zweite Schalter (S₂) vorhanden ist, den zweiten Schalter (S₂) in Abhängigkeit zumindest eines detektierten Wertes aus:
- Ladestrom (I_{ES}),
- Eingangsstrom (Iₑᵢₙ),
- Aussgangsstrom (Iₐᵤₛ),
- Ladespannung (U_{ES}),
- Eingangsspannung (Uₑᵢₙ),
- Ausgangsspannung (Uₐᵤₛ), und
- Schalterspannung (U_{S1})
anzusteuern.

9. Verfahren zum Betrieb einer Schutzschaltung (1) nach einem der vorangehenden Ansprüche, **gekennzeichnet durch** die durchgeführten Schritte:
- Versorgen der Steuerung (9) der Schutzschaltung (1) mit elektrischer Energie aus dem Energiespeicher, wobei
- die Schutzschaltung (1) in einem ersten Betriebszustand betrieben wird, solange die an den Eingangsanschlüssen (2a, 2b) anliegende Eingangsspannung Uₑᵢₙ innerhalb eines ersten Wertebereiches mit positiver Eingangsspannung Uₑᵢₙ liegt, wobei in dem ersten Betriebszustand ein Laden des Energiespeichers über die Eingangsanschlüsse (2a, 2b) bei dauerhaft geschlossenem ersten Schalter (S₁) erfolgt; und wobei
- die Schutzschaltung (1) in einem zweiten Betriebszustand betrieben wird, solange die an den Eingangsanschlüssen (2a, 2b) anliegende Eingangsspannung Uₑᵢₙ innerhalb eines zweiten Wertebereiches mit negativer Eingangsspannung Uₑᵢₙ liegt, wobei in dem zweiten Betriebszustand ein Laden des Energiespeichers über die Ausgangsanschlüsse (3a, 3b) **durch** ein wiederholtes temporäres Öffnen des ersten Schalters (S₁) erfolgt; und wobei
- die Schutzschaltung (1) bei Vorliegen vordefinierter Rahmenbedingungen zusätzlich in einem dritten Betriebszustand betrieben wird, bei dem der erste Schalter (S₁) dauerhaft geöffnet ist, wobei in dem dritten Betriebszustand ein Laden des Energiespeichers über die Eingangsanschlüsse (2a, 2b) erfolgt, wobei die vordefinierten Rahmenbedingungen, bei deren Vorliegen die Schutzschaltung (1) im dritten Betriebszustand betrieben wird, ein von der Schutzschaltung (1) empfangenes Signal oder ein Ausbleiben eines von der Schutzschaltung (1) zuvor empfangenen Signals aufweisen.

10. Verfahren nach Anspruch 9, soweit zurückbezogen auf Anspruch 5, wobei in dem dritten Betriebszustand der Schutzschaltung (1) die Eingangsspannung (Uₑᵢₙ) an den Eingangsanschlüssen (2a, 2b) durch ein Schließen des zweiten Schalters (S₂) unterhalb eines zweiten Grenzwertes gehalten wird, und wobei der zweite Schalter (S₂) zum Laden des Energiespeichers wiederholt temporär geöffnet wird.

11. Verfahren nach Anspruch 9 oder 10, wobei das wiederholte temporäre Öffnen des ersten Schalters (S₁) im zweiten Betriebszustand und/oder - soweit die Schutzschaltung den zweiten Schalter (S₂) aufweist - das wiederholte temporäre Öffnen des zweiten Schalters (S₂) im dritten Betriebszustand eine getaktete Ansteuerung mit einem Tastgrad ist, wobei der Tastgrad in Abhängigkeit einer über den Energiespeicher abfallenden Ladespannung (U_{ES}) bestimmt wird.

12. Verfahren nach einem der Ansprüche 9 bis 11, wobei ein Übergang der Schutzschaltung (1) in den dritten Betriebszustand zumindest einen der folgenden Schritte aufweist:
- Betreiben des ersten Schalters (S₁) für eine erste Zeitdauer in einem in Abhängigkeit der über dem ersten Schalter (S₁) abfallenden Schalterspannung (U_{S1}) geregelten Linearbetrieb,
- Betreiben des ersten Schalters (S₁) für eine zweite Zeitdauer in einem Linearbetrieb bei einer über dem ersten Schalter (S₁) abfallenden zeitlich ansteigenden Schalterspannung (Usi)
- Verschieben eines Arbeitspunktes des an die Schutzschaltung (1) angeschlossenen PV-Moduls (10) oder aller PV-Module (10) der Serienschaltung von PV-Modulen (10) in Richtung einer Leerlaufspannung der PV-Module (10) über einen an die Serienschaltung von PV-Modulen (10) angeschlossenen Photovoltaik (PV) - Wechselrichter und Herbeiführen einer damit verbundenen Leistungsreduktion der Serienschaltung von PV-Modulen (10).

13. Verfahren nach einem der Ansprüche 9 bis 12, soweit zurückbezogen auf Anspruch 5, wobei ein Übergang der Schutzschaltung (1) in den dritten Betriebszustand die folgenden Schritte aufweist:
- Herbeiführen einer Leistungsreduktion der Serienschaltung von PV-Modulen (10), vor einem Öffnen des ersten Schalters (S₁), wobei
- das Herbeiführen der Leistungsreduktion ein Schließen des zweiten Schalters (S₂) der Schutzschaltung (1) oder ein Schließen der zweiten Schalter (S₂) mehrerer Schutzschaltungen (1) von PV-Modulen (10) innerhalb der Serienschaltung von PV-Modulen (10) aufweist.

14. Verfahren nach Anspruch 13, wobei ein Schließen des zweiten Schalters (S₂) der Schutzschaltung (1) oder ein Schließen der zweiten Schalter (S₂) mehrerer Schutzschaltungen (1) von PV-Modulen (10) innerhalb der Serienschaltung von PV-Modulen (10) derart erfolgt, dass
- der jeweilig zu schließende zweite Schalter (S₂) beim Übergang von dem geöffneten in den geschlossenen Zustand während einer dritten Zeitdauer in einem Linearbetrieb mit zeitlich abnehmendem ohmschen Widerstand betrieben wird, wobei
- der Ausgangsstrom (Iₐᵤₛ) detektiert wird, und wobei
- der erste Schalter (S₁) dann geöffnet wird, wenn ein Betrag des Ausgangsstrom (Iₐᵤₛ) einen Stromschwellwert unterschreitet.

15. Photovoltaik (PV) - Anlage aufweisend einen PV - Wechselrichter mit zumindest einer an den PV-Wechselrichter angeschlossen Serienschaltung von PV-Modulen (10), wobei zumindest eines der PV-Module (10) eine Schutzschaltung (1) gemäß einem der Ansprüche 1 bis 8 aufweist.

## Claims

1. A protective circuit (1) for a photovoltaic (PV) module (10), comprising
- an input having two input terminals (2a, 2b) for connecting the PV module (10),
- an output having two output terminals (3a, 3b) for connecting further PV modules (10) of a series circuit comprising PV modules (10),
- a first switch (S₁) for connecting one of the input terminals (2a, 2b) to one of the output terminals (3a, 3b), and
- a controller (9) configured for controlling the first switch (S₁),
- wherein the protective circuit (1) furthermore comprises a series circuit comprising a first diode (4) and an energy store, wherein the series circuit is arranged in parallel with the input of the protective circuit (1),
- wherein the protective circuit (1) furthermore comprises a second diode (6), which connects an output terminal (3a, 3b) of the protective circuit (1) to a midpoint (12) of the series circuit comprising the first diode (4) and the energy store,
**characterized**
- **in that** a series circuit comprising the second diode (6) and the energy store is connected in parallel with the first switch (S₁).

2. The protective circuit (1) as claimed in claim 1, **characterized in that** an anode of the first diode (4) is connected to an anode of the second diode (6) via the midpoint (12) of the series circuit comprising the first diode (4) and the energy store, or **in that** a cathode of the first diode (4) is connected to a cathode of the second diode (6) via the midpoint (12) of the series circuit comprising the first diode (4) and the energy store.

3. The protective circuit (1) as claimed in claim 1 or 2, **characterized in that** the anode of the first diode (4) is connected to the input terminal (2a) assigned to a positive pole of the PV module (10) or **in that** the cathode of the first diode (4) is connected to the input terminal (2b) assigned to a negative pole of the PV module (10).

4. The protective circuit (1) as claimed in any of the preceding claims, **characterized in that** the protective circuit furthermore comprises a bypass path (13) in parallel with the input of the protective circuit (1), wherein the bypass path (13) optionally comprises a third diode (14), which is connected by its anode to the input terminal (2b) of the protective circuit (1) that is assigned to the negative pole of the PV module (10), and by its cathode to the input terminal (2a) of the protective circuit (1) that is assigned to the positive pole of the PV module (10).

5. The protective circuit (1) as claimed in claim 4, **characterized in that** the bypass path (13) comprises a second switch (S₂), which is controllable via the controller (9).

6. The protective circuit (1) as claimed in any of the preceding claims, **characterized in that** the protective circuit (1) comprises a communication unit (11) configured to receive an external signal for controlling the first switch (S₁) and/or, if the second switch is present, the second switch (S₂).

7. The protective circuit (1) as claimed in claim 6, **characterized in that** the communication unit (11) is configured to enable power line communication via a line connected to the output terminal (3a, 3b), and wherein the protective circuit (1) optionally comprises a path of low impedance for a power line signal in parallel with the output of the protective circuit (1), wherein the path comprises a series circuit comprising an inductance and a capacitor.

8. The protective circuit (1) as claimed in any of claims 6 or 7, **characterized in that** the protective circuit (1) comprises at least one of the following components:
- a first current sensor (7.1) for detecting a charging current (I_{ES}) flowing in the series circuit comprising the first diode (4) and the energy store directed to the energy store or directed away from the energy store,
- a second current sensor (7.2) for detecting an input current (Iᵢₙ) flowing between the PV module (10) and one of the input terminals (2a, 2b) of the protective circuit (1),
- a third current sensor (7.3) for detecting an output current (Iₒᵤₜ) flowing between one of the output terminals (3a, 3b) of the protective circuit (1) and the further PV modules (10) connected to the protective circuit (1),
- a first voltage sensor (8.1) for detecting a charging voltage (U_{ES}) dropped across the energy store,
- a second voltage sensor (8.2) for detecting an input voltage (Uᵢₙ) present between the input terminals (2a, 2b) of the protective circuit (1),
- a third voltage sensor (8.3) for detecting an output voltage (Uₒᵤₜ) present between the output terminals (3a, 3b) of the protective circuit (1), and
- a fourth voltage sensor (8.4) for detecting a switch voltage (U_{S1}) dropped across the first switch (S₁) and wherein the controller (9) is configured to control the first switch (S₁) and/or, if the second switch is present, the second switch (S₂) depending on at least one detected value from:
- Charging current (I_{ES}),
- Input current (Iᵢₙ),
- Output current (Iₒᵤₜ),
- Charging voltage (U_{ES}),
- Input voltage (Uᵢₙ),
- Output voltage (Uₒᵤₜ), and
- Switch voltage (U_{S1}).

9. A method for operating a protective circuit (1) as claimed in any of the preceding claims, **characterized by** the following steps carried out:
- supplying the controller (9) of the protective circuit (1) with electrical energy from the energy store, wherein
- the protective circuit (1) is operated in a first operating state as long as the input voltage Uᵢₙ present at the input terminals (2a, 2b) lies within a first value range with positive input voltage Uᵢₙ, wherein in the first operating state the energy store is charged via the input terminals (2a, 2b) with the first switch (S₁) permanently closed; and wherein
- the protective circuit (1) is operated in a second operating state as long as the input voltage Uᵢₙ present at the input terminals (2a, 2b) lies within a second value range with negative input voltage Uᵢₙ, wherein in the second operating state the energy store is charged via the output terminals (3a, 3b) by a repeated temporary opening of the first switch (S₁); and wherein
- the protective circuit (1), given the presence of predefined boundary conditions, is additionally operated in a third operating state, in which the first switch (S₁) is permanently open, wherein in the third operating state the energy store is charged via the input terminals (2a, 2b), wherein the predefined boundary conditions whose presence results in the protective circuit (1) being operated in the third operating state comprise a signal received by the protective circuit (1) or an absence of a signal previously received by the protective circuit (1).

10. The method as claimed in claim 9, insofar as referring back to claim 5, wherein in the third operating state of the protective circuit (1) the input voltage (Uᵢₙ) at the input terminals (2a, 2b) is kept below a second limit value by closing of the second switch (S₂), and wherein the second switch (S₂) is repeatedly temporarily opened for the purpose of charging the energy store.

11. The method as claimed in any of claims 9 or 10, wherein the repeated temporary opening of the first switch (S₁) in the second operating state and/or - provided that the protective circuit comprises the second switch (S₂) - the repeated temporary opening of the second switch (S₂) in the third operating state are/is clocked driving with a duty cycle, wherein the duty cycle is determined depending on a charging voltage (U_{ES}), dropped across the energy store.

12. The method as claimed in any of claims 9 to 11, wherein a transition of the protective circuit (1) into the third operating state comprises at least one of the following steps:
- operating the first switch (S₁) for a first time duration in a linear operation mode regulated depending on the switch voltage (U_{S1}) dropped across the first switch (S₁),
- operating the first switch (S₁) for a second time duration in linear operation mode at a temporally rising switch voltage (U_{S1}) dropped across the first switch (S₁),
- shifting an operating point of the PV module (10) connected to the protective circuit (1) or of all PV modules (10) of the series circuit comprising PV modules (10) in the direction of an open circuit voltage of the PV modules (10) via a photovoltaic PV inverter connected to the series circuit comprising PV modules (10), and bringing about an associated power reduction of the series circuit comprising PV modules (10).

13. The method as claimed in any of claims 9 to 12, insofar as referring back to claim 5, wherein a transition of the protective circuit (1) into the third operating state comprises the following steps:
- bringing about a power reduction of the series circuit comprising PV modules (10), before an opening of the first switch (S1), wherein
- bringing about the power reduction comprises closing the second switch (S2) of the protective circuit (1) or closing the second switches (S2) of a plurality of protective circuits (1) of PV modules (10) within the series circuit comprising PV modules (10).

14. The method as claimed in claim 13, wherein closing the second switch (S₂) of the protective circuit (1) or closing the second switches (S₂) of a plurality of protective circuits (1) of PV modules (10) within the series circuit comprising PV modules (10) takes place in such a way that
- the second switch (S₂) respectively to be closed, upon the transition from the open to the closed state, is operated during a third time duration in linear operation with a temporally decreasing ohmic resistance, wherein
- the output current (Iₒᵤₜ) is detected, and wherein
- the first switch (S₁) is opened if a magnitude of the output current (Iₒᵤₜ) undershoots a current threshold value.

15. A photovoltaic (PV) system comprising a PV inverter with at least one series circuit comprising PV modules (10) that is connected to the PV inverter, wherein at least one of the PV modules (10) comprises a protective circuit (1) as claimed in any of claims 1 to 8.

## Revendications

1. Circuit de protection (1) pour un module (10) photovoltaïque (PV), comportant :
- une entrée avec deux bornes d'entrée (2a, 2b) pour le branchement du module PV (10) ;
- une sortie avec deux bornes de sortie (3a, 3b) pour le branchement de modules PV (10) supplémentaires d'un circuit en série de modules PV (10) ;
- un premier contacteur (S₁) pour la liaison d'une des bornes d'entrée (2a, 2b) avec une des bornes de sortie (3a, 3b) ; et
- un élément de commande (9) configuré pour commander le premier contacteur (S₁),
- le circuit de protection (1) comportant en outre un circuit en série d'une première diode (4) et d'un accumulateur d'énergie, le circuit en série étant disposé parallèlement à l'entrée du circuit de protection (1) ;
- le circuit de protection (1) comportant en outre une deuxième diode (6) reliant une borne de sortie (3a, 3b) du circuit de protection (1) à un point central (12) du circuit en série composé de la première diode (4) et de l'accumulateur d'énergie ;
**caractérisé en ce que** :
un circuit en série composé de la deuxième diode (6) et de l'accumulateur d'énergie est connecté parallèlement au premier contacteur (S₁).

2. Circuit de protection (1) selon la revendication 1, **caractérisé en ce qu'une** anode de la première diode (4) est reliée à une anode de la deuxième diode (6) par l'intermédiaire du point central (12) du circuit en série composé de la première diode (4) et de l'accumulateur d'énergie ou qu'une cathode de la première diode (4) est reliée à une cathode de la deuxième diode (6) par l'intermédiaire du point central (12) du circuit en série composé de la première diode (4) et de l'accumulateur d'énergie.

3. Circuit de protection (1) selon la revendication 1 ou 2, **caractérisé en ce que** l'anode de la première diode (4) est reliée à la borne d'entrée (2a) associée à un pôle positif du module PV (10) ou que la cathode de la première diode (4) est reliée à la borne d'entrée (2b) associée à un pôle négatif du module PV (10).

4. Circuit de protection (1) selon l'une quelconque des revendications précédentes, **caractérisé en ce que** le circuit de protection comprend en outre un circuit de dérivation (13) s'étendant parallèlement à l'entrée du circuit de protection (1), le circuit de dérivation (13) comportant en option une troisième diode (14) reliée, avec sa anode, à la borne d'entrée (2b) du circuit de protection (1) associée au pôle négatif du module PV (10) et, avec sa cathode, à la borne d'entrée (2a) du circuit de protection (1) associée au pôle positif du module PV (10) .

5. Circuit de protection (1) selon la revendication 4, **caractérisé en ce que** le circuit de dérivation (13) comporte un deuxième contacteur (S₂) pouvant être excité par l'intermédiaire de l'élément de commande (9).

6. Circuit de protection (1) selon l'une quelconque des revendications précédentes, **caractérisé en ce que** le circuit de protection (1) comporte une unité de communication (11) qui est configurée pour recevoir un signal externe destiné à exciter le premier contacteur (S₁) et / ou, en cas de deuxième contacteur (S₂), le deuxième contacteur (S₂).

7. Circuit de protection (1) selon la revendication 6, **caractérisé en ce que** l'unité de communication (11) est configurée pour permettre une communication Power-Line via un câble raccordé à la borne de sortie (3a, 3b) et le circuit de protection (1) comportant en option un signal Power-Line de chemin à impédance basse parallèle à la sortie du circuit de protection (1), le chemin comportant un circuit en série composé d'un élément inductif et d'un condensateur.

8. Circuit de protection (1) selon la revendication 6 ou 7, **caractérisé en ce que** le circuit de protection (1) comporte au moins un des composants suivants :
- un premier détecteur de courant (7.1) permettant de détecter le courant de charge (I_{ES}) circulant dans le circuit en série composé de la première diode (4) et de l'accumulateur d'énergie, vers l'accumulateur d'énergie ou depuis l'accumulateur d'énergie ;
- un deuxième détecteur de courant (7.2) permettant de détecter un courant d'entrée (Iₑᵢₙ) circulant entre le module PV (10) et une des bornes d'entrée (2a, 2b) du circuit de protection (1) ;
- un troisième détecteur de courant (7.3) permettant de détecter un courant de sortie (Iₐᵤₛ) circulant entre une des bornes de sortie (3a, 3b) du circuit de protection (1) et les modules PV (10) supplémentaires raccordés au circuit de protection (1) ;
- un premier détecteur de tension (8.1) permettant de détecter une tension de charge (U_{ES}) baissant via l'accumulateur d'énergie ;
- un deuxième détecteur de tension (8.2) permettant de détecter une tension d'entrée (Uₑᵢₙ) présente entre les bornes d'entrée (2a, 2b) du circuit de protection (1) ;
- un troisième détecteur de tension (8.3) permettant de détecter une tension de sortie (Uₐᵤₛ) présente entre les bornes de sortie (3a, 3b) du circuit de protection ; et
- un quatrième détecteur de tension (8.4) permettant de détecter une tension de contacteur (U_{S1}) baissant via le premier contacteur (S₁) et l'élément de commande (9) étant configuré pour commander le premier contacteur (S₁) et/ou, en cas de deuxième contacteur (S₂), le deuxième contacteur (S₂) en fonction d'au moins une valeur détectée :
- courant de charge (I_{ES}) ;
- courant d'entrée (Iₑᵢₙ) ;
- courant de sortie (Iₐᵤₛ) ;
- tension de charge (U_{ES}) ;
- tension d'entrée (Uₑᵢₙ) ;
- tension de sortie (Uₐᵤₛ) ; et
- tension de contacteur (U_{S1}).

9. Procédé d'utilisation d'un circuit de protection (1) selon l'une quelconque des revendications précédentes, **caractérisé par** les étapes suivantes :
- alimentation de l'élément de commande (9) du circuit de protection (1) en énergie électrique provenant de l'accumulateur d'énergie ;
- le circuit de protection (1) étant entraîné, dans un premier état de fonctionnement, tant que la tension d'entrée Uₑᵢₙ présente au niveau des bornes d'entrée (2a, 2b) se situe à l'intérieur d'une première plage de valeurs avec tension d'entrée Uₑᵢₙ positive, une charge de l'accumulateur d'énergie étant réalisée dans le premier état de fonctionnement via les bornes d'entrée (2a, 2b) lorsque le premier contacteur (S₁) est fermé de façon durable ; et
- le circuit de protection (1) étant entraîné, dans un deuxième état de fonctionnement, tant que la tension d'entrée Uₑᵢₙ présente au niveau des bornes d'entrée (2a, 2b) se situe à l'intérieur d'une deuxième plage de valeurs avec tension d'entrée Uₑᵢₙ négative, une charge de l'accumulateur d'énergie étant réalisée dans le deuxième état de fonctionnement via les bornes de sortie (3a, 3b) par une ouverture temporaire répétée du premier contacteur (S₁) ; et
- le circuit de protection (1) étant en outre entraîné, en présence de conditions-cadres prédéfinies, dans un troisième état de fonctionnement dans lequel le premier contacteur (S₁) est ouvert de façon durable, une charge de l'accumulateur d'énergie étant réalisée, dans le troisième état de fonctionnement, via les bornes d'entrée (2a, 2b), les conditions-cadres prédéfinies pour lesquelles le circuit de protection (1) est entraîné dans le troisième état de fonctionnement étant un signal reçu du circuit de protection (1) ou une absence de signal précédemment reçu du circuit de protection (1).

10. Procédé selon la revendication 9, se rapportant à la revendication 5, dans lequel dans le troisième état de fonctionnement du circuit de protection (1), la tension d'entrée (Uₑᵢₙ) est maintenue en dessous d'une deuxième valeur limite au niveau des bornes d'entrée (2a, 2b) par une fermeture du deuxième contacteur (S₂) et le deuxième contacteur (S₂) étant temporairement ouvert de façon répétée pour la charge de l'accumulateur d'énergie.

11. Procédé selon la revendication 9 ou 10, dans lequel l'ouverture temporaire répétée du premier contacteur (S₁) dans le deuxième état de fonctionnement et/ou - en cas de deuxième contacteur (S₂) dans le circuit de protection - l'ouverture temporaire répétée du deuxième contacteur (S₂) dans le troisième état de fonctionnement est une excitation cadencée avec une densité d'impulsions, la densité d'impulsions étant définie en fonction d'une tension de charge (U_{ES}) baissant via l'accumulateur d'énergie.

12. Procédé selon l'une quelconque des revendications 9 à 11, une transition di circuit de protection (1) comportant, dans un troisième état de fonctionnement, au moins une des étapes suivantes :
- entraînement du premier contacteur (S₁) pendant une première durée dans un fonctionnement linéaire réglé en fonction de la tension de contacteur (U_{S1}) baissant via le premier contacteur (S₁) ;
- entraînement du premier contacteur (S₁) pendant une deuxième durée dans un fonctionnement linéaire, à une tension de contacteur (U_{S1}) augmentant dans le temps et baissant au niveau du premier contacteur (S₁) ;
- déplacement d'un point de travail du module PV (10) raccordé au circuit de protection (1) ou de tous les modules PV (10) du circuit en série depuis les modules PV (10) en direction d'une tension à vide des modules PV (10) via un ondulateur photovoltaïque (PV) raccordé au circuit en série de modules PV (10) entraînant une réduction de puissance pour le circuit en série de modules PV (10).

13. Procédé selon l'une quelconque des revendications 9 à 12, ramenées à la revendication 5, dans lequel une transition du circuit de protection (1) dans le troisième état de fonctionnement comporte les étapes suivantes :
- introduction d'une réduction de puissance du circuit en série de modules PV (10), avant une ouverture du premier contacteur (S₁) ;
- introduction de la réduction de puissance comportant une fermeture du deuxième contacteur (S₂) du circuit de protection (1) ou une fermeture du deuxième contacteur (S₂) de plusieurs circuits de protection (1) de modules PV (10) à l'intérieur du circuit en série de modules PV (10).

14. Procédé selon la revendication 13, dans lequel une fermeture du deuxième contacteur (S₂) du circuit de protection (1) ou une fermeture du deuxième contacteur (S₂) de plusieurs circuits de protection (1) de modules PV (10) se produit à l'intérieur du circuit en série de modules PV (10), de telle sorte que :
- le deuxième contacteur (S₂) à fermer respectivement est entraîné en fonctionnement linéaire lors de la transition par la résistance ohmique ouverte diminuant dans le temps à l'état fermé pendant une troisième durée ;
- le courant de sortie (Iₐᵤₛ) étant détecté ; et
- le premier contacteur (S₁) étant ouvert lorsque la quantité de courant de sortie (Iₐᵤₛ) passe en dessous d'une valeur seuil de courant.

15. Installation photovoltaïque (PV) comportant un ondulateur PV avec au moins un circuit en série raccordé à l'ondulateur PV composé de modules PV (10), au moins un des modules PV (10) comportant un circuit de protection (1) selon l'une quelconque des revendications 1 à 8.
